# EUROPEAN PATENT APPLICATION

(11) **EP 1 775 632 A1**
(43) Date of publication of application: **18.04.2007**
(21) Application number: 05765714.0
(22) Date of filing: 12.07.2005
(51) Int. Cl.: G03F 7/039, G03F 7/00, G03F 7/004

(54) **POSITIVE-WORKING PHOTOSENSITIVE COMPOSITION**

(30) Priority: 02.08.2004 JP 2004226008
(71) Applicant: THINK LABORATORY CO., LTD., Chiba, 227-8525 (JP)
(72) Inventor: SATO, Tsutomu, THINK LABORATORY CO., LTD., Kashiwa-shi, Chiba 2778525 (JP); KA, Seihei, THINK LABORATORY CO., LTD., Kashiwa-shi, Chiba 2778525 (JP)
(74) Representative: Grünecker, Kinkeldey, Stockmair & Schwanhäusser Anwaltssozietät
(86) International application number: PCT/JP2005/012824
(87) International publication number: WO 2006/013704

(57) **Abstract**

There is provided a positive photosensitive composition which requires no burning, makes it possible to obtain necessary and sufficient adhesion when it is applied under a humidity of 25 to 60%, is excellent in stability on standing and reproducibility, can be developed at a low alkali intensity, makes it possible to carry out development with keeping high sensitivity while forming no residue, ensures sharp edges, can provide a very hard resist film and is improved in scratch resistance in the handling before development. The positive photosensitive composition comprises, as essential components, (A) a high molecular substance having at least one carboxyl group and/or at least one acid anhydride group in a molecule thereof, (B) an amine compound, and (C) a photo-thermal conversion material that absorbs infrared rays from an image exposure light source to convert the rays to heat.

## Description

### Technical Field:

The present invention relates to a positive photosensitive composition, and, particularly, to an alkali-soluble positive photosensitive composition which requires no burning and has sensitivity to an infrared wavelength region laser so that when exposed to the laser light having a wavelength of 700 to 1,100 nm, the sensitized portion becomes soluble in an alkali developer. The positive photosensitive composition according to the present invention may be effectively used in photofabrication and especially used in the field of photo- fabrication applied to the production of printing plates, electronic parts, precision mechanical equipment parts, members relevant to prevention of forgery or the like.

### Background Art:

A conventional positive photolithographic printing plate contains a novolak resin and an o-quinonediazide compound which is a substance sensitive to white light. It is known that as shown in the following formula (I), due to photo-decomposition (chemical change), the o-quinonediazide compound causes an Arndt-Eistert type rearrangement to form a ketene structure, thereby generating a five-membered ring carboxylic acid in the presence of water, and as shown in the following formula (II), ketene present in the upper part of the photosensitive layer of the exposed portion is reacted with naphthoquinonediazide present in the lower part of the photosensitive layer to form lactone, at development by an alkaline aqueous solution, this lactone ring opens to form sodium carboxylate, and also, since the coexisting novolak resin is alkali-soluble, the sodium carboxylate elutes together with the novolak resin, while the photosensitive layer of the unexposed portion enters into a coupling reaction with the coexisting novolak resin by the aid of the alkaline solution used at development as shown in the following formula (III), with the result that it becomes sparingly soluble in alkali and is left as a resist image (see Non-patent document 1). When the o-quinonediazide compound is contained, wide latitude of development is obtained.

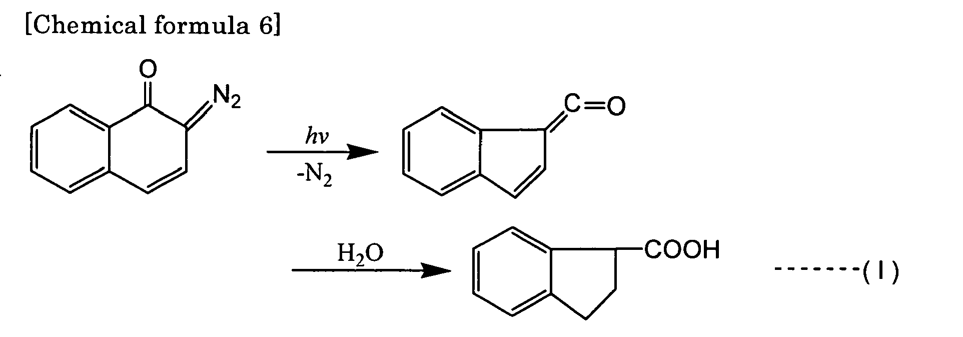

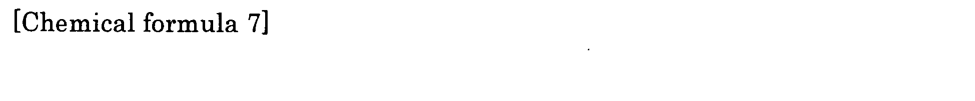

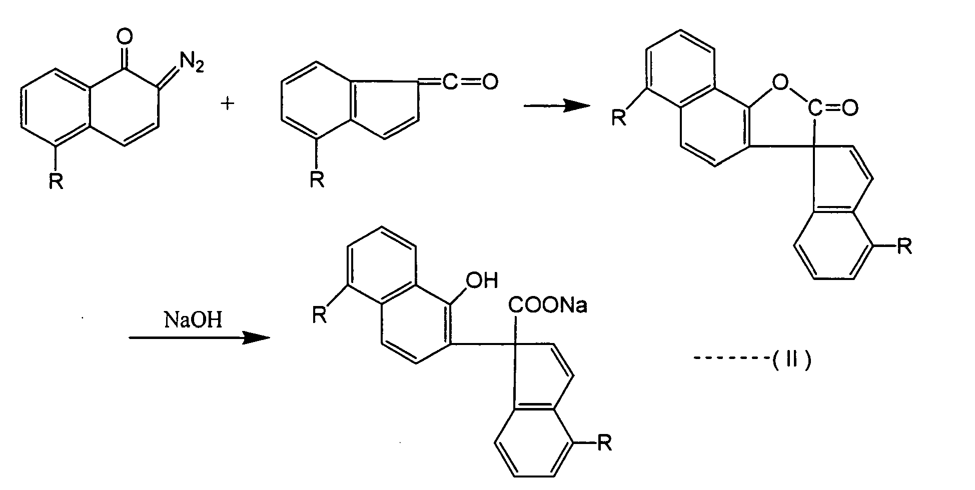

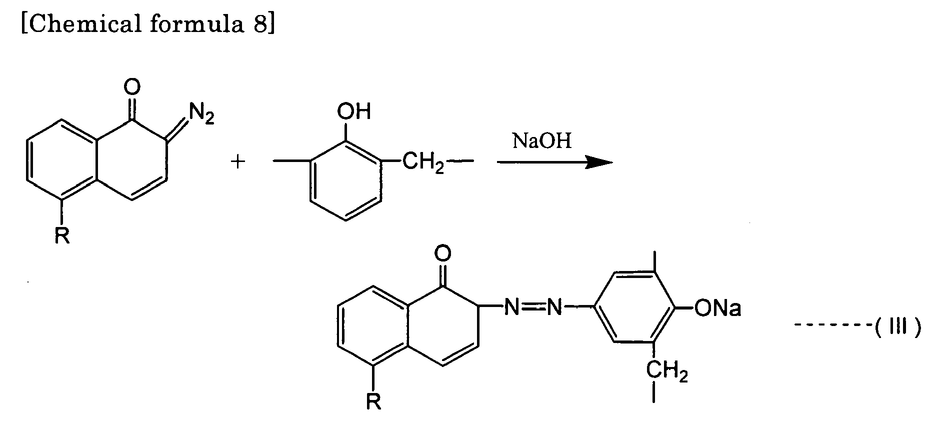

In the present specification, the term "have latitude of development" means such a condition that plate-making can be made stably under the situation that the film thickness is not changed in the development (loss of the film thickness is little), the area of the dots is not changed for a prescribed developing time and a phenomenon that a residue (what is left) suddenly appears does not occur.

In the meantime, a positive photosensitive composition utilizing a change other than chemical changes is invented to accomplish plate-making under a white lamp, and a method is studied out in which a positive image is printed by an infrared wavelength region laser to increase the solubility of the exposed portion in a developing solution, thereby forming a positive image. This method is put into practice in offset-plate-making and flexo- plate-making (see, for example, Patent documents 1 to 10).

The positive photosensitive lithographic printing plates described in the above each reference contain a substance, such as an infrared ray absorbing dye, that absorbs infrared light to convert it into heat and an alkali-soluble resin such as a novolak resin as major components of the photosensitive layer and a physical change such as the conformation change of the resin is caused by heat generated by exposure to light from an infrared laser to thereby increase the solubility of these components in a developing solution.

However, the positive photosensitive lithographic printing plate, which contains no o-quinonediazide compound and is operated to increase the solubility by printing a positive image by laser light of an infrared wavelength region to cause a physical change such as the conformation change of the resin, needs burning (heating operation) after coating at present. Under present situation, even if the burning is conducted, a difference in dissolution rate between an exposed portion and an unexposed portion is still small, the fundamental performances of printing plates such as sensitivity and latitude of development are inferior and it is difficult to satisfy developing stability when increasing the number of sheets to be developed.

On the contrary, the situation is utterly different in the case of gravure-plate-making. In Japan where gravure-plate-making/printing is most widely spread, a gravure-plate-making method in which gravure-plate- making can be conducted using a positive thermal resist which may be developed under no heating after the resist is applied, has not been carried out at all and nowhere found in Patent documents and experimental documents.

Conditionally, a gravure-plate-making process of a plate-making roll by an etching method/laser-plate-making method involves, for example, following steps: loading/degreasing/washing with water/washing with an acid/washing with water/Ballard treatment/washing with water/Ballard copper plating/washing with water/grinding using an abrasive/washing with water/coating with a photosensitive agent/coating with an antioxidant/ printing of an image by an exposure apparatus using an infrared laser/ development/washing with water/etching/washing with water/peeling of a resist/washing with water/chrome plating/washing with water/grinding/ washing with water/unloading. Examples of technical documents disclosing the gravure-plate-making process of a plate-making roll by the etching method/laser-plate-making method may include Patent documents 11 to 29.

In all the gravure-plate-making processes described in the above documents, a photosensitive film comprising a negative photosensitive composition is formed by application but a photosensitive film comprising a positive photosensitive composition is not formed by application. In conventional etching methods, a negative photosensitive film is applied to a plate-making roll and dried up at room temperature to form a negative photosensitive film, which is then printed by an argon ion laser. However, a method in which a positive photosensitive film is formed on the plate-making roll to print a positive photosensitive film image by laser light having infrared wavelengths is not carried out.

A high power semiconductor laser head manufactured by CreoScitex Co., Ltd. in Canada is a type emitting a laser having a wavelength falling in the infrared region, is mounted on an offset printer, where a positive photo- sensitive composition is irradiated with the laser light and is probably well developed, and is thus put into practical use world-wide.

If the beam diameter of argon ion laser light is the same in size as the beam diameter of laser light having a wavelength of 700 to 1,100 nm, laser resolution is higher and process time can be substantially more reduced in the case of a positive type than in the case of a negative type.

Moreover, the sharpness of a pattern is better in the case of printing a positive image on a photosensitive film of a positive photosensitive composition by a laser having a wavelength falling in the infrared region than in the case of printing a negative image on a photosensitive film of a negative photosensitive composition by an argon ion laser. This is considered to be due to a difference in the sharpness of a pattern caused by a difference between a positive photosensitive composition and a negative photosensitive composition.

The reason why a positive photosensitive composition has not been used in gravure-print-making although it is used in offset-plate-making and flexo-plate-making in the prior art is that a negative photosensitive agent can be used in gravure-plate-making. Since a negative photosensitive agent is used to secure the degree of polymerization of a resin of the exposed portion by irradiating the resin with ultraviolet rays, a necessary and sufficient latitude of development can be ensured even if any material is used as the material to be coated.

In the meantime, there has been no positive photosensitive composition having latitude of development that can be satisfied in relation to copper sulfate plating of a gravure-printing roll. This is particularly because there has been no photosensitive composition that is not processed by burning after applied. There is no condition allowing the formation of a coat if a positive photosensitive composition which is used in offset-plate- making or flexo-plate-making is applied to gravure-plate-making roll. In many cases, a coat of a positive photosensitive composition to gravure-plate- making roll is flowed away by the alkali developer completely. Even if burning is conducted after coating, the same results will be obtained.

A high resolution gravure-plate-making system using a semiconductor laser or YAG laser which outputs high power laser light having a wavelength falling in the infrared region and using a positive photosensitive film has been desired to be put into practice from the viewpoint of downsizing of a device, environmental light during plate-making work, resolution and the sharpness of a pattern as compared with the case of using an argon ion laser.
Patent document 1: JP-A No. 10-268512
Patent document 2: JP-A No. 11-194504
Patent document 3: JP-A No. 11-223936
Patent document 4: JP-A No. 11-84657
Patent document 5: JP-A No. 11-174681
Patent document 6: JP-A No. 11-231515
Patent document 7: WO97/39894
Patent document 8: WO98/42507
Patent document 9: JP-A No. 2002-189293
Patent document 10: JP-A No. 2002-189294
Patent document 11: JP-A No. 10-193551
Patent document 12: JP-A No. 10-193552
Patent document 13: JP-A No. 2000-062342
Patent document 14: JP-A No. 2000-062343
Patent document 15: JP-A No. 2000-062344
Patent document 16: JP-A No. 2001-179923
Patent document 17: JP-A No. 2001-179924
Patent document 18: JP-A No. 2001-187440
Patent document 19: JP-A No. 2001-187441
Patent document 20: JP-A No. 2001-191475
Patent document 21: JP-A No. 2001-191476
Patent document 22: JP-A No. 2001-260304
Patent document 23: JP-A No. 2002-127369
Patent document 24: JP-A No. 2002-187249
Patent document 25: JP-A No. 2002-187250
Patent document 26: JP-A No. 2002-200728
Patent document 27: JP-A No. 2002-200729
Patent document 28: JP-A No. 2002-307640
Patent document 29: JP-A No. 2002-307641
Patent document 30: JP-A No. 2004-133025
Patent document 31: JP-B No. 47-25470
Patent document 32: JP-B No. 48-85679
Patent document 33: JP-B No. 51-21572
Non-patent document 1: Gentaro Nagamatsu and Hideo Inui, "Photosensitive polymer", Kodansha, Sept. 1, 1978, p. 104-122

### Disclosure of the Invention:

### Problems to be solved by the Invention:

The present inventor, in view of the above situation, started developing a positive photosensitive composition having necessary and sufficient latitude of development without burning after coating as to the relation of a gravure-printing roll to copper sulfate plating. After various investigations, the following matter was able to be attained: there is used a positive photosensitive composition wherein, as an adhesion agent, a titanium organic compound is added to an undiluted solution of a positive photosensitive composition comprising an alkali-soluble organic polymer material having a phenolic hydroxyl group and a photo-thermal conversion material which absorbs infrared rays from an image-exposure light source to convert the rays to heat, so as to form a photosensitive film on a copper sulfate plated roll at room temperature of 25°C, apply light-exposure thereto into a test image by means of an infrared laser exposure apparatus (manufactured by Think Laboratory CO., LTD.) and develop the film, thereby lowering the burning temperature thereof remarkably (see Patent Document 30).

However, in the case of a photosensitive film of the above-mentioned positive photosensitive composition, to which a titanium organic compound is added, burning is still required therefor even if the burning temperature can be lowered to about 50°C. Thus, the following problems remain: the film is required to be cooled after the burning; time and energy are necessary for the burning and the subsequent cooling; and the apparatus line becomes long by the length of the burning device, so that costs for facilities and the running costs thereof increase.

Furthermore, if burning is performed, it takes 30 to 60 minutes to raise the temperature of the roll to a necessary temperature and it takes 50 to 100 minutes or more to cool the roll to room temperature because the roll is increased in heat load unlike a thin plate material. Also, these times differ depending on the size of the roll and it is therefore impossible to control the temperature uniformly. Also, the practice of the burning causes a cyanine dye to be denatured, leading to reduced sensitivity and low sharpness of a pattern, and also at the time of development causes the resist to be thin which is a cause of the retardation of an outline and the generation of pinholes. It has been therefore desired to develop a positive photosensitive film free from the necessity of burning.

The present invention relates to a positive photosensitive composition which is sensitized when it is exposed to laser light having a wavelength of 700 to 1,100 nm, the sensitized portion being made soluble in an alkali developing solution. It is an object of the present invention to provide a positive photosensitive composition having the following characteristics: 1) when the composition is applied in an application working room in which the humidity is in a range from 25 to 60%, it is applied to a subject to be coated, the subsequent burning is not required, and necessary and sufficient adhesion to aluminum, of course and also to copper or copper sulfate plating which requires very stronger adhesion than aluminum is obtained; 2) good alkali development free from the generation of residues can be accomplished in a proper time of about 60 to 70 seconds and it is possible to develop even if the alkali strength of a developing solution is low, which makes easy to carry out working during development and to treat waste solutions; 3) the composition is excellent in stability on standing and reproducibility; 4) no burning treatment is carried out and high sensitivity is therefore maintained, and the edge of a resist image has an outline cut sharply in accordance with the exposure irradiated pattern, making it possible to attain very good development; 5) a reduction in film thickness after development is small and the generation of pinholes caused by the film reduction is reduced, ensuring very good development; 6) a resist image is glossy, it is possible to attain a resist image having printing durability ensuring that several thousand sheets can be copied if it is subjected to printing as it is and the scratching resistance of the photosensitive film is improved in the handling before development after the photosensitive film is formed; and 7) image printing by a laser and a latitude of development are superior.

### Means for Solving the Problems:

In order to solve the above-mentioned problems, the inventors have repeated eager researches so as to find out that the above-mentioned excellent advantageous effects 1) to 7) (for example, no burning is required and a large development latitude can be obtained) can be produced according to a positive photosensitive composition comprising a photo-thermal conversion material which absorbs infrared rays from an image-exposure light source to convert the rays to heat, and an amine compound, wherein a polymer material having a carboxyl group and/or an acid anhydride group is used instead of the alkali-soluble organic polymer material having a phenolic hydroxyl group.

Accordingly, the positive photosensitive composition of the present invention, for which no burning is necessary, comprises:
(A) a high molecular substance having at least one carboxyl group and/or at least one acid anhydride group in a molecule thereof,
(B) an amine compound, and
(C) a photo-thermal conversion material that absorbs infrared rays from an image exposure light source to convert the rays to heat.

The high molecular substance (A) is preferably at least one high molecular compound selected from the group consisting of a polymer obtained from an unsaturated compound (a1) having at least one carboxyl group and/or at least one carboxylic acid anhydride group and a copolymer obtained from the unsaturated compound (a1) and a compound (a2) copolymerizable with the unsaturated compound.

The unsaturated compound (a1) is preferably at least one compound selected from the group consisting of maleic acid, (meth)acrylic acid and their derivatives. In the present invention, acryl and methacryl are collectively called (meth)acryl.

The high molecular substance (A) is preferably at least one polymer selected from the group consisting of a maleic acid polymer, a (meth)acrylic acid polymer and a styrene/maleic acid copolymer and their derivative.

The high molecular substance (A) is preferably a styrene/maleic acid copolymer obtained by reaction of a styrene/maleic anhydride copolymer with a compound having a hydroxyl group. The compound having a hydroxyl group is preferably an alcohol.

The high molecular substance (A) is preferably a copolymer represented by the following general formula (1).

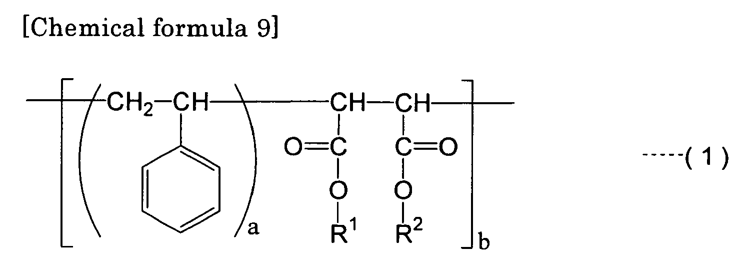

In the formula (1), each of "R¹" and "R²" independently represents a hydrogen atom or a substituted or unsubstituted alkyl group, "a" denotes an integer from 1 to 3 and "b" denotes an integer from 6 to 8.

It is preferred that the positive photosensitive composition of the present invention further includes (D) a dissolution inhibitor.

It is preferred that the dissolution inhibitor (D) is a compound represented by the following chemical formula (2):

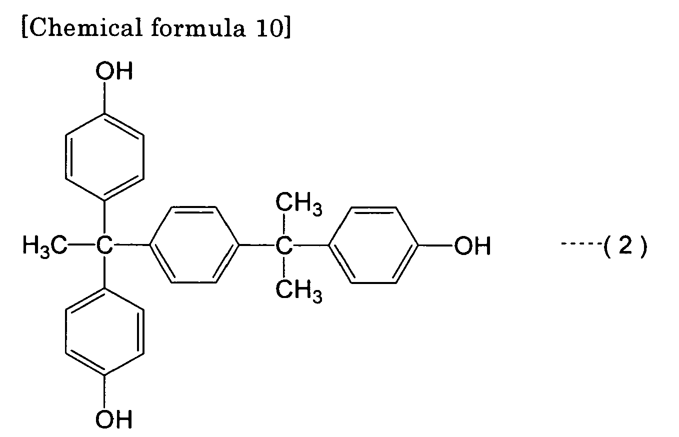

It is preferred that the photo-thermal conversion material (C) is a compound represented by the following general formula (3):

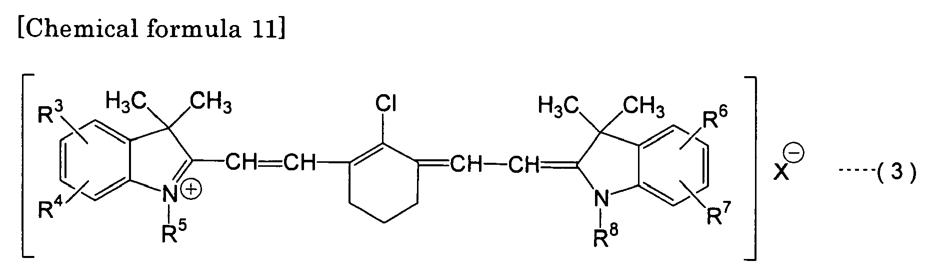

In the formula (3), each of "R³" to "R⁸" independently represents a hydrogen atom, an alkyl group having 1 to 3 carbon atoms or an alkoxyl group having 1 to 3 carbon atoms, "X" represents a halogen atom, C10₄, BF₄, p-CH₃C₆H₄SO₃ or PF₆.

It is preferred that the photo-thermal conversion material (C) is a compound represented by the following general formula (4):

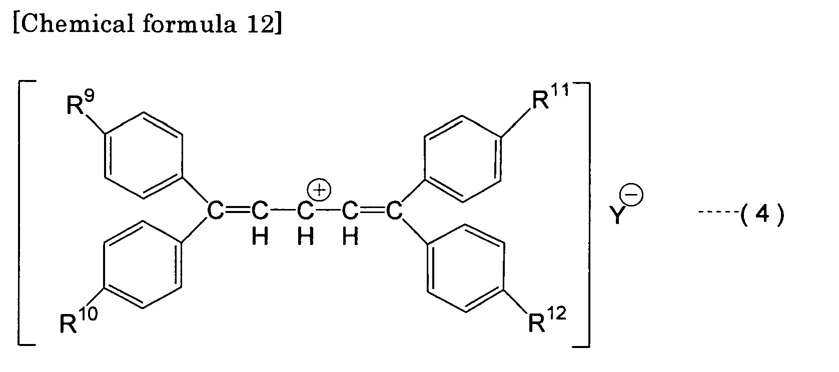

In the formula (4), each of "R⁹" to "R¹²" independently represents a hydrogen atom, a methoxyl group, -N(CH₃)₂ or -N(C₂H₅)₂ and "Y" represents C₄H₉-B(C₆H₅)₃, *p*-CH₃C₆H₄SO₃ or CF₃SO₃.

It is preferred that the positive photosensitive composition of the present invention further includes (E) a photo-acid generator. The photo-acid generator (E) is preferably a compound represented by the following formula (5):

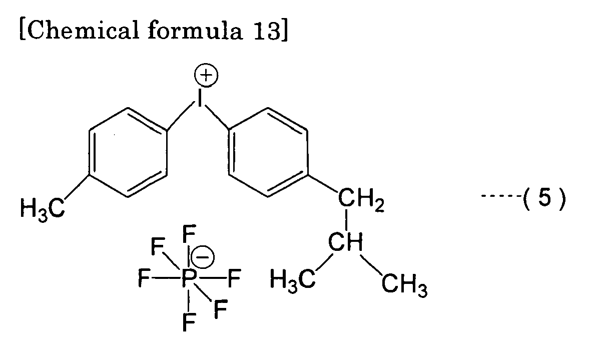

It is preferred that the positive photosensitive composition of the present invention further includes (F) at least one resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinylcaprolactam/dimethylaminoethyl 1 methacrylate copolymer, (4) polyvinyl acetate, (5) polyvinyl butyral, (6) polyvinyl formal, (7) a terpene phenol resin (8) an alkylphenolic resin (9) a melamine-formaldehyde resin, and (10) a ketone resin.

It is preferred that the positive photosensitive composition of the present invention further includes (G) a triarylmethane dye.

The amine compound (B) is preferably an aminoalcohol.

A photo-fabrication method of the present invention comprises using the positive photosensitive composition of the present invention. The photo- fabrication method is preferably applied to production of a printing plate, an electronic component, a precision equipment component and a component relating to a counterfeit deterrence.

A plate-making method of the present invention comprises using the positive photosensitive composition of the present invention. Printing plates such as an intaglio (gravure), lithography, relief and mimeograph may be produced by the plate-making method of the present invention.

A general plate-making process of a gravure plate using the positive photosensitive composition of the present invention as a sensitizing solution is as follows.
1. Application of a sensitizing solution to a cylinder (dry film thickness: preferably 2 to 5 µm, the film is preferably thicker to reduce pinholes, but the film is preferably thinner because the amount of the solution to be used is reduced and the production cost is reduced that much) → 2. Drying (until touch dry: 15 minutes → until end: 15 to 20 minutes) → 3. Exposure (light source: semiconductor laser 830 nm, 220 mJ/cm²) → 4. Development (60 to 90 seconds/25°C) → 5. Washing with water (spray, 30 seconds) → 6. Etching (depth: 10 to 30 µm, etching: a solution of cupric chloride in water, conversion of copper: 60 g/L) → 7. Peeling of resist (peeling using an alkali) → 8. Washing with water → 9. Cr plating (chromic acid: 250 g/L, sulfuric acid: 2.5 g/L in water) → 10. Washing with water → 11. Printing.

A general plate-making process of a lithography (PS plate) using the positive photosensitive composition of the present invention as a sensitizing solution is as follows.
1. CTP (PS plate) (aluminum abrasion → application of a sensitizing solution → drying) → 2. Exposure (light source: semiconductor laser 830 nm, 220 mJ/cm²) → 3. Development → 4. Printing.

### Effect of the Invention:

The positive photosensitive composition of the present invention is alkali-soluble positive photosensitive composition that is sensitized when exposed to laser light in the infrared wavelength region wherein the exposed portion becomes soluble in a developing solution. The composition has the following excellent effects.
(1) Necessary and sufficient adhesion to aluminum and copper as well as even to a less adhesive subject to be coated such as glossy and mirror-like plated copper can be obtained without burning. Also, even though burning is not carried out, a photosensitive film having the same glossiness as in the conventional case of carrying out burning can be obtained.
(2) Necessary and insufficient adhesion is obtained in the condition of humidity of 25 to 60%.
(3) Good alkali development is accomplished without any generation of residues in a proper time. Although the photosensitive layer components are not substantially changed chemically by exposure to light, all of the basic performances of a printing plate such as printing durability, sensitivity and latitude of development can be satisfied. Also, since a high molecular substance having carboxyl group is used, development can be carried if the strength of an alkali developing solution is low. Since development can be carried out at a pH range of developing solution from 10 to 12, the amount of carbonic acid gas dissolved in air is small and a reduction in the pH of an alkali developing solution with time is small that much. On the other hand, a developing solution for phenolic resin is reduced in pH immediately after the preparation of the developing solution by the effect of carbonic acid gas and development cannot be accomplished continuously if a buffer solution is not used as the developing solution. A developing solution that is not a buffer solution will be reduced in alkali concentration in 2 to 3 days at most. In such a situation, the composition is controlled more easily as to a reduction in alkali concentration than a phenolic resin that is developed by a developing solution at a pH of 13.0 or more. Also, the range of selection of the alkali developer is widened and at the same time, waste treatment is easy because the strength of an alkali waste solution is low. The preparation of the developing solution: means that an undiluted solution of a developing solution is diluted with water in a developing tank to form a developing solution.)
(4) The composition is excellent in stability on standing and reproducibility.
(5) Even if image exposure is carried out using an exposure energy lower than high exposure energy causing the generation of excess heat due to a photo-thermal conversion material in the photosensitive layer, a wide latitude of development can be adopted. Therefore, because the generation of scattering of the photosensitive layer is limited to a low level, the problem that the photosensitive layer is scattered (made abrasion) to contaminate the optical system of an exposure apparatus does not arise.
(6) No burning treatment is carried out, which ensures that high sensitivity is maintained and makes it possible to attain such good development that the edge of a resist image has an outline cut sharply in accordance with the exposure irradiated pattern. Also, with regard to the end surface part, a uniform film thickness after development can be maintained as there is no dispersion of heat capacity caused by burning.
(7) A resist image is decreased in a reduction in film thickness and is glossy; pinholes are not produced even if the layer is just etched and gravure-plate- making can be accomplished. Also, a resist image is obtained which has printing durability ensuring that several thousand sheets can be copied if it is subjected to, for example, printing, and the generation of pinholes in the handling before development after the photosensitive film is dried can be avoided or scratching resistance is improved.
(8) A variation in image printing by a laser is reduced and latitude of development is superior.
(9) A reduction in film thickness after development is small and therefore the generation of pinholes is decreased.

### Brief Description of the Drawing:

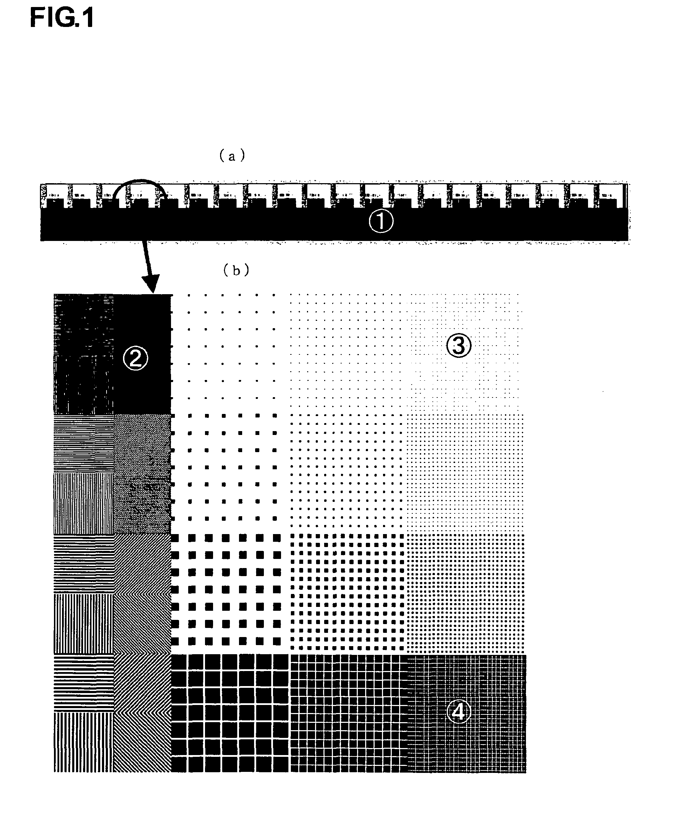

Fig. 1 is a view showing a sensitizing solution test pattern used in Example 1 and measuring positions, where (a) is a test pattern and (b) is an enlarged view of the part marked by a circle in (a).

### Best Mode for Carrying Out the Invention:

Embodiments of the present invention will be described hereinafter, and these embodiments are illustrative. Of course, therefore, the embodiments can be variously modified as long as the modified embodiments do not depart from the technical conception of the present invention.

The positive photosensitive composition of the present invention includes, as essential elements, (A) a high molecular substance having at least one carboxyl group and/or at least one acid anhydride group in a molecule thereof, (B) an amine compound, and (C) a photo-thermal conversion material that absorbs infrared rays from an image exposure light source to convert the rays to heat, and, according to the need, preferably further comprises (D) a dissolution inhibitor, (E) a photo-acid generator, (F) at least one resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinylcaprolactam/dimethylaminoethyl methacrylate copolymer, (4) polyvinyl acetate, (5) polyvinyl butyral, (6) polyvinyl formal, (7) a terpene phenol resin, (8) an alkylphenol resin, (9) a melamine/formaldehyde resin, and (10) a ketone resin, and (G) a triarylmethane dye.

As the aforementioned high molecular substance (A), any high molecular substance may be used without any particular limitation insofar as it has at least one carboxyl group in its molecule. Preferable examples of the high molecular substance include a polymer of an unsaturated compound (a1) having at least one carboxyl group and/or at least one carboxylic acid anhydride group and a copolymer of the unsaturated compound (a1) and a compound (a2) copolymerizable with the unsaturated compound. The high molecular substance (A) contains the carboxyl group so as to have an acid value of preferably 30 to 500 and more preferably 200 to 250. The weight average molecular weight of the high molecular substance (A) is preferably 1,500 to 100,000 and more preferably about 7,000 to 10,000.

As the aforementioned unsaturated compound (a1), maleic acid, (meth)acrylic acid, fumaric acid and itaconic acid, and their derivatives are preferable. These compounds may be used either singly or in combinations of two or more.

Preferable examples of the aforementioned maleic acid and its derivative (referred to as a maleic acid monomer) include maleic acid, maleic anhydride, maleic monoester (e.g., monomethyl maleate, monoethyl maleate, mono-*n*-propyl maleate, mono-isopropyl maleate, mono-n-butyl maleate, mono-isobutyl maleate and mono-*tert-*butyl maleate) and maleic diester.

Preferable examples of the aforementioned (meth)acrylic acid and its derivative (referred to as a (meth)acryl monomer) include (meth)acrylic acid and (meth)acrylic ester (e.g., methyl (meth)acrylate, ethyl (meth)acrylate, butyl (meth)acrylate and hydroxyethyl (meth)acrylate).

As the compound (a2) copolymerizable with the unsaturated compound (a1), compounds having an unsaturated double bond are preferable and styrene and its derivatives (referred to as styrene monomer) such as styrene, α-methylstyrene, *m*- or *p*-methoxystyrene, *p*-methylstyrene, *p*-hydroxystyrene, 3-hydroxymethyl-4-hydroxy-styrene are particularly preferable. These compounds may be used either singly or in combinations of two or more.

As the aforementioned high molecular substance (A), a polymer of the aforementioned maleic acid monomer, a copolymer of the maleic acid monomer used as major components, a polymer of the aforementioned (meth)acryl monomer, a copolymer of the (meth)acryl monomer used as major components, a copolymer of the maleic acid monomer, the (meth)acryl monomer and other monomer such as the styrene monomer, a styrene/maleic acid copolymer (hereinafter referred to as a copolymer (b 1)) obtained by copolymerizing the maleic acid monomer with the styrene monomer, a copolymer of the (meth)acryl monomer and the styrene monomer, derivatives of these polymers or modifications of these polymers are preferable, maleic acid polymer, (meth)acrylic acid polymer, a copolymer having a structure represented by the following general formula (6) and/or the general formula (7) and a structure represented by the following general formula (8) or a copolymer of (meth)acrylic acid, (meth)acrylic acid ester and the styrene monomer are more preferable and a copolymer represented by the following general formula (1) are further more preferable.

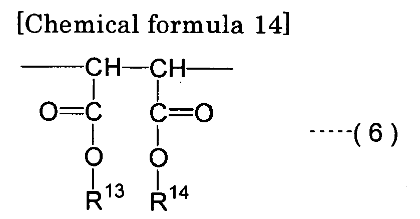

In the formula (6), each of "R¹³ and "R¹⁴ independently represents a hydrogen atom or a monovalent substituted group and is preferably a hydrogen atom, a lower alkyl group or a group having a reactive double bond.

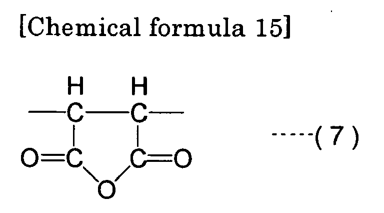

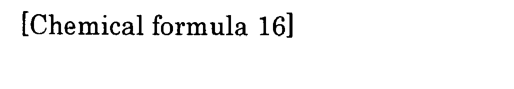

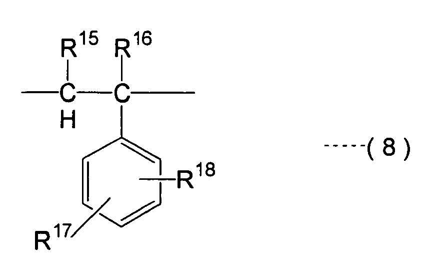

In the formula (8), each of "R¹⁵" and "R¹⁶" independently represents a hydrogen atom or a monovalent substituted group is preferably a hydrogen atom or a methyl group, "R¹⁷" represents a hydrogen atom or a monovalent substituted group and is preferably a hydrogen atom, a hydroxyl group, an alkyl group or an alkoxyl group, and "R¹⁸" represents a hydrogen atom or a monovalent substituted group and is preferably a hydrogen atom a hydroxyalkyl group.

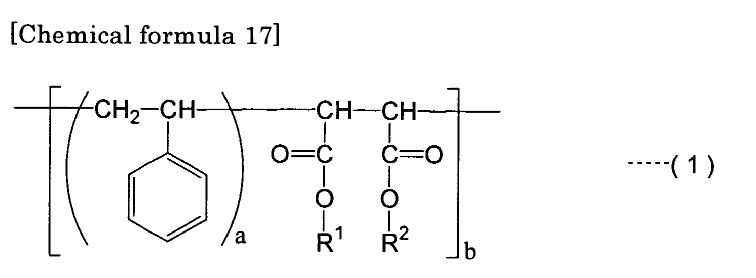

In the formula (1), each of "R¹" and "R²" independently represents a hydrogen atom or a monovalent substituted group, and is preferably a hydrogen atom or a substituted or unsubstituted alkyl group and more preferably a hydrogen atom, a lower alkyl group or an alkoxyalkyl group. When "R¹" and "R²" are respectively present in plural, plural "R¹"s and plural "R²"s may be the same or different. At least one of "R¹" and "R²" is preferably a hydrogen atom. "a" denotes an integer from 0 or 1 or more and is preferably 1 to 3. "b" denotes an integer of 1 or more and is preferably 6 to 8.

No particular limitation is imposed on the method for producing the above styrene/maleic acid copolymer and the copolymer may be produced according to a known method. It is preferable to react a styrene/maleic anhydride copolymer (namely, a copolymer of the styrene monomer and maleic anhydride) with a compound having a hydroxyl group to esterify, thereby obtaining the above styrene/maleic acid copolymer.

Examples of the compound having a hydroxyl group include, though not particularly limited to, alcohols such as isopropanol, *n*-propanol, isopropanol/cyclohexanol, butyl alcohol, isooctanol and ethylene glycol, ethylene glycol ethers such as ethylene glycol butyl ether, and diethylene glycol ethers such as diethylene glycol ethyl ether.

Also, as the aforementioned high molecular substance (A), compounds (hereinafter referred to as a copolymer (b2)) obtained by modifying the aforementioned copolymer (b1) by using a compound having a reactive double bond may be used. In this case, the ratio of the structure represented by the formulae (6) and (7) to the structure represented by the formula (8) is preferably about 1. Specifically, it is possible to produce the above copolymer (b2) by reacting an acid hydride group or carboxyl group in the copolymer (b1) with the compound having a reactive double bond. In this case, it is necessary that a carboxyl group necessary to carry out alkali development be left in the copolymer.

As the compound having a reactive double bond, a compound having a carbon-carbon double bond is preferable. Preferable examples of the compound having a reactive double bond include an unsaturated alcohol (e.g., allyl alcohol, 2-butene-1-2-ol, furfuryl alcohol, oleyl alcohol, cinnamyl alcohol, 2-hydroxyethyl acrylate, hydroxyethyl methacrylate and N-methylol acryl- amide), alkyl (meth)acrylate (e.g., methyl methacrylate and *t*-butyl methacrylate), an epoxy compound having one oxirane ring and one reactive double bond (e.g., glycidyl acrylate, glycidyl methacrylate, allyl glycidyl ether, α-ethylglycidyl acrylate, crotonyl glycidyl ether and itaconic acid monoalkyl monoglycidyl ester).

As the above copolymer (b2), a compound may be used which is obtained by reacting a compound into which a reactive double bond is introduced by an unsaturated alcohol, with the above epoxy compound having one oxirane ring and one reactive double bond, to thereby increase the concentration of a reactive double bond.

No particular limitation is imposed on a method for producing the above copolymer (b1) or (b2) and the method may be carried out according to a known method (see, for example, Patent documents 31 to 33). A reactive double bond may be introduced also into the high molecular substance having a carboxyl group, other than a styrene/maleic acid polymer in the same manner as above. The imparting of a reactive double bond to the high molecular substance is preferable from the viewpoint of raising hardness and improving printing durability.

There is no particular limitation to the content of the high molecular substance (A) in the positive photosensitive composition of the present invention. However, the content is preferably 80 to 98% by weight and more preferably 90 to 95% by weight based on the total solid amount of the components (A) to (G). The high molecular substance (A) may be used either singly or in combinations of two or more.

The amine compound (B) is an amine and a derivative thereof. Preferred examples thereof include aliphatic amines, aliphatic unsaturated amines, alicyclic amines, aromatic amines, heterocyclic amines such as morpholine and piperazine, and aminoalcohols and aminoalcohols are preferred. Preferred examples of the aminoalcohols include methylethanolamine, ethylethanolamine, dimethylethanolamine, diethylethanolamine, dibutylethanolamine, methyldiethanolamine, and diethylisopropanolamine.

There is no particular limitation to the content of the amine compound (B) in the positive photosensitive composition of the present invention. However, the content is preferably 5% or less by weight and more preferably 0.1 to 0.4% by weight based on the total solid amount of the components (A) to (G). The above-mentioned amine compounds (B) may be used either singly or in combinations of two or more.

As the above photo-thermal conversion material (B), any material may be used insofar as it is a compound capable of converting absorbed light into heat. Examples of the photo-thermal conversion material (C) include organic or inorganic pigments and dyes, organic coloring matter, metals, metal oxides, metal carbonates and metal borates, which have an absorption band in a part or all of the infrared region of wavelength of 700 to 1,100 nm. A preferable example of the photo-thermal conversion material (B) is a light- absorbing dye that efficiently absorbs light having the above wavelength range and does not almost absorb light in the ultraviolet region or does not substantially sensitized by the light if it absorbs the light. A Compound represented by the following formula (3) or (4) and their derivatives are preferably used.

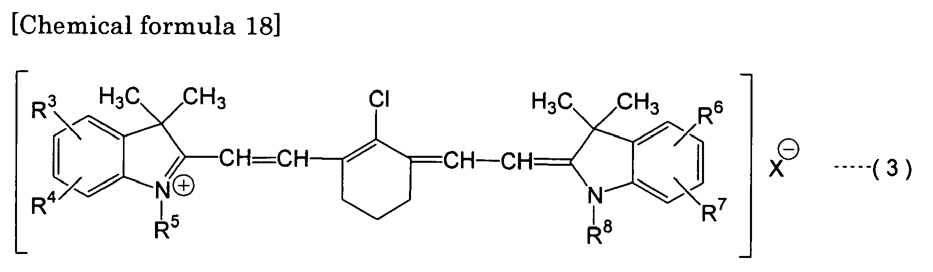

In the formula (3), each of "R³" to "R⁸" independently represents a hydrogen atom, a lower alkyl group (preferably an alkyl group having 1 to 3 carbon atoms) or a lower alkoxyl group (preferably an alkoxyl group having 1 to 3 carbon atoms). "X-" represents a counter anion and examples of "X" include a halogen atom, C10₄, BF₄, *p*-CH₃C₆H₄SO₃ or PF₆.

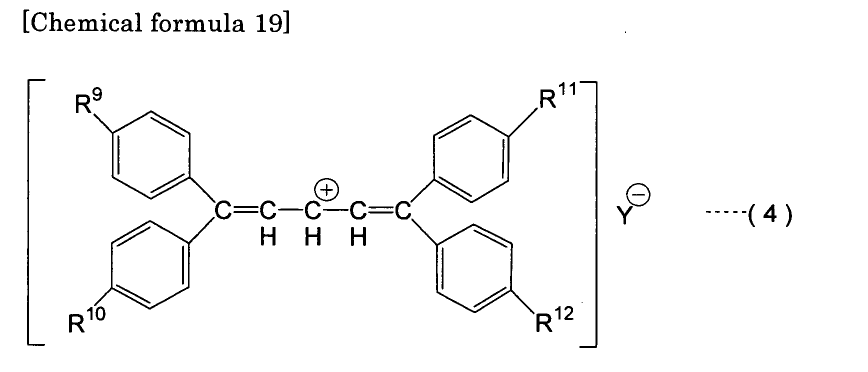

In the formula (4), each of "R⁹" to "R¹²" independently represents a hydrogen atom, a methoxyl group, -N(CH₃)₂ or -N(C₂H₅)₂ and "Y-" represents a counter anion. Examples of "Y" include C₄H₉-B(C₆H₅)₃, *p*-CH₃C₆H₄SO₃ or CF₃SO₃.

As the compound represented by the formula (4), near-infrared ray absorbing dyes are preferable which have the maximum absorption wavelength in the near-infrared region and are represented by the following formulae (9) to (12).

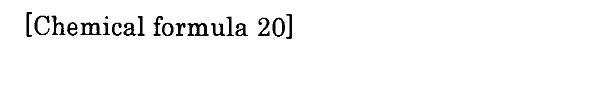

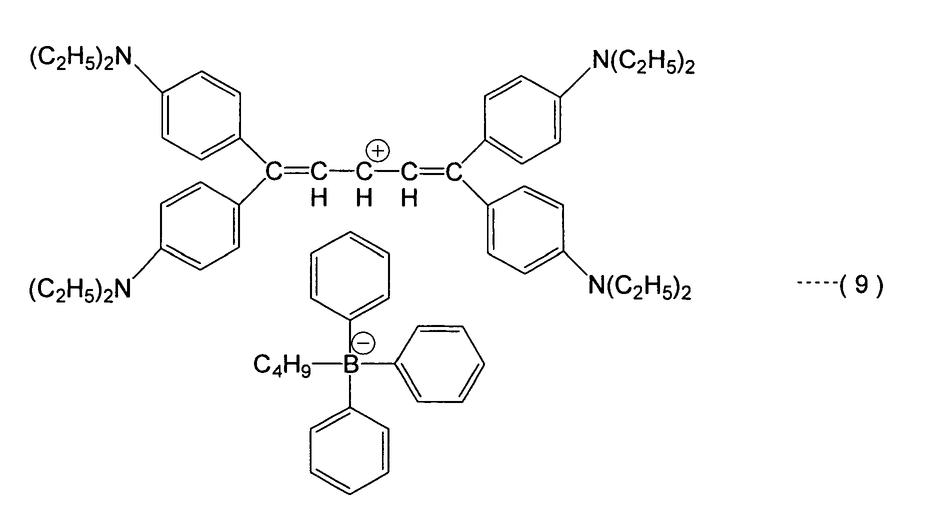

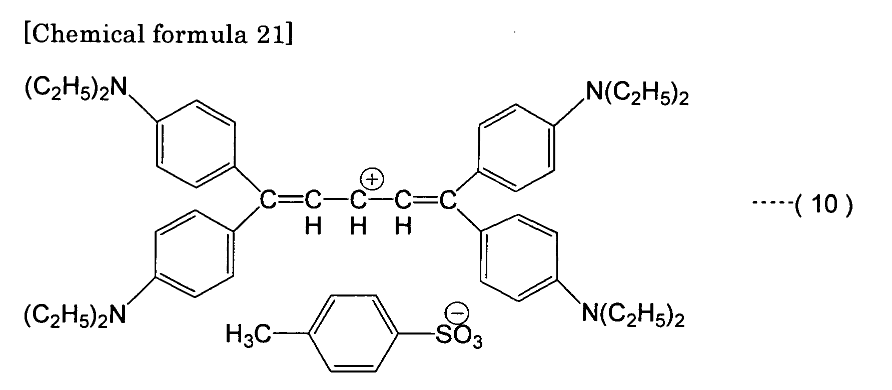

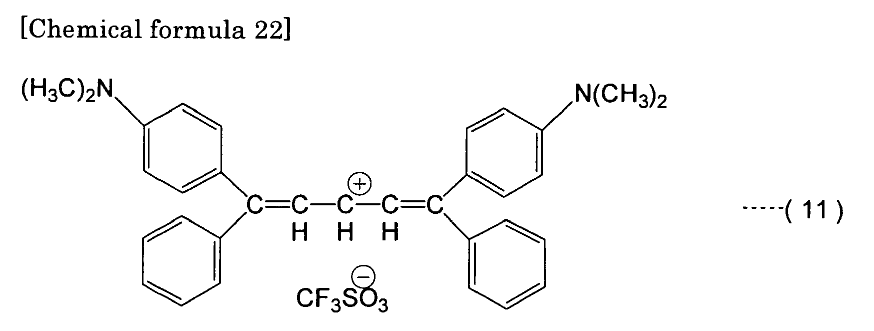

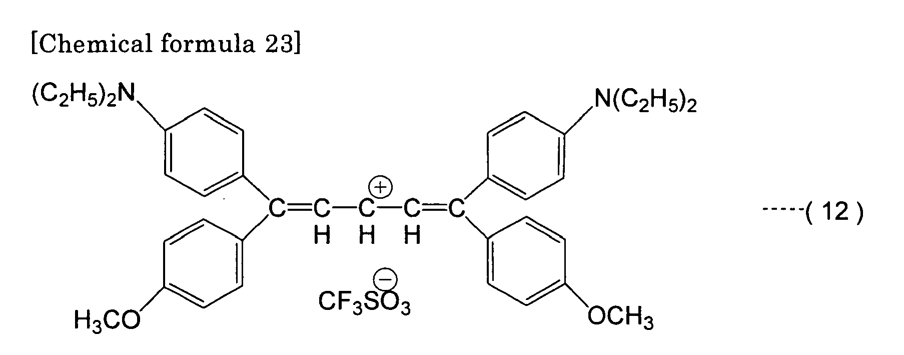

Also, examples of other light-absorbing dyes include cyanine dyes so-called in a wide sense which have the structure in which a heterocyclic ring containing a nitrogen atom, an oxygen atom or a sulfur atom are combined by a polymethine (-CH=)ₙ as described in Patent document 6. Specific examples of these cyanine dyes include a quinoline type (so-called cyanine type), indole type (so-called indocyanine type), benzothiazole type (so-called thiocyanine type), iminocyclohexadiene type (so-called polymethine type), pyrylium type, thiapyrylium type, squarylium type, croconium type and azulenium type. Among these types, a quinoline type, indole type, benzothiazole type, iminocyclohexadiene type, pyrylium type or thiapyrylium type is preferable. Particularly, phthalocyanine or cyanine is preferable.

The aforementioned photo-thermal conversion material (C) has an absorption band in a part or all of the infrared region of a wavelength of 700 to 1,100 nm, has the characteristics that it absorbs laser light of the infrared wavelength region to be heat-decomposed, and participates in molecular reduction/abrasion relative to alkali solubility which is caused by thermal cutting of a molecule of the high molecular substance (A) having a carboxyl group.

The quantity of the photo-thermal conversion material to be added relates to whether heat generated in exposure is excessive or insufficient and also, the intensity of the infrared laser relates to whether the heat decomposition of organic high molecular substance existing in the exposed portion is excessive or insufficient. Therefore, the amount of the photo-thermal conversion material is designed to be an appropriate amount. The content of the photo-thermal conversion material (C) in the positive photo- sensitive composition of the present invention is preferably 0.1 to 10% by weight and more preferably 1 to 4% by weight based on the total solid amount of the components (A) to (G).

The aforementioned dissolution inhibitor (D) is compounded for the purpose of increasing a time difference of solubility in an alkali developing solution between an exposed portion and an unexposed portion. As the dissolution inhibitor (D), a compound is used which has the ability of forming a hydrogen bond together with the high molecular substance (A) to reduce the solubility of the high molecular substance, does not almost absorb light in the infrared region and is not decomposed by light in the infrared region.

As the dissolution inhibitor (D), it is preferable to use the compound (4,4'-[1-[4-[1-(4-hydroxyphenyl)-1-methyl ethyl] phenyl] ethylidene] bis- phenol) represented by the following formula (2).

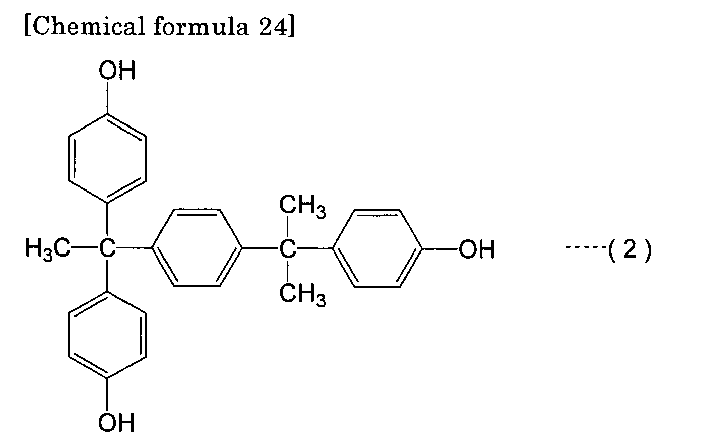

Also, known dissolution inhibitors may be used as the dissolution inhibitor (D). Specific examples of the dissolution inhibitor (D) include a sulfonic ester, phosphoric ester, aromatic carboxylic ester, aromatic disulfone, carboxyanhydride, aromatic ketone, aromatic aldehyde, aromatic amine, aromatic ether, acid color developing dyes having a lactone skeleton, thio- lactone skeleton, N,N-diaryl amide skeleton or diaryl methylimino skeleton, base color developing dyes having lactone skeleton, thiolactone skeleton or sulfolactone skeleton, nonionic surfactant and so on. Among these materials, acid color developing dye having lactone skeleton is preferable.

The content of the dissolution inhibitor (D) in the positive photosensitive composition of the present invention is preferably 0.5 to 8% by weight and more preferably 1 to 5% by weight based on the total solid amount of the components (A) to (G). These dissolution inhibitors may be used either singly or in combinations of two or more.

The foregoing photo-acid generator (E) is a material that generates an acid by the aid of light and acts as a photo sensitizer. Examples of the photo-acid generator (E) include a diphenyliodonium salt, triphenylsulfonium salt, aromatic sulfonic ester, triazine compound and diazodisulfone type compound. Compounds represented by the following formulae (13) to (47) are preferable and compounds represented by the following formula (5) are particularly preferable.

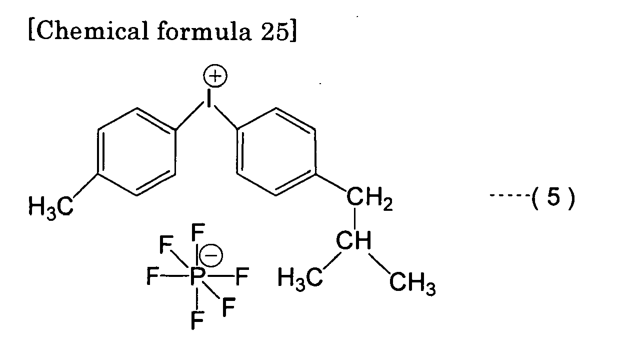

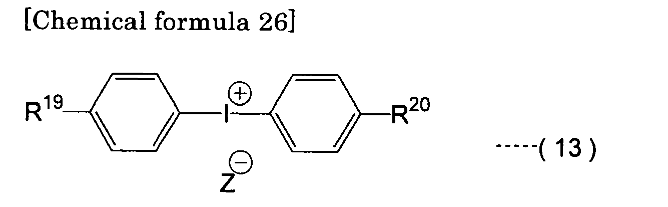

In the formula (13), each of "R¹⁹" and "R²⁰" independently represents a hydrogen atom, an alkyl group or an alkoxyl group, and is preferably a hydrogen atom, a methyl group, a *tert*-butyl group, a methylpropyl group or methoxyl group. "Z" represents a counter anion and examples of "Z" include inorganic acid anions such as PF₆, CF₃SO₃, C₄F₉SO₃, SbF₆ and BF₄, and organic acid anions such as *p*-toluenesulfonic acid and camphor-β- sulfonic acid.

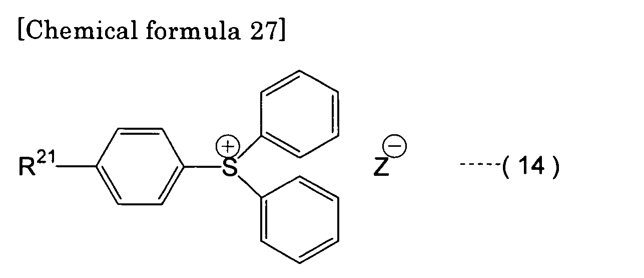

In the formula (14), "R²¹" represents a hydrogen atom, an alkyl group, an alkoxyl group or an -SC₆H₅ group, and is preferably a hydrogen atom, a methyl group, a *tert-*butyl group, a methylpropyl group or a methoxyl group. "Z" is the same as that shown in the formula (13).

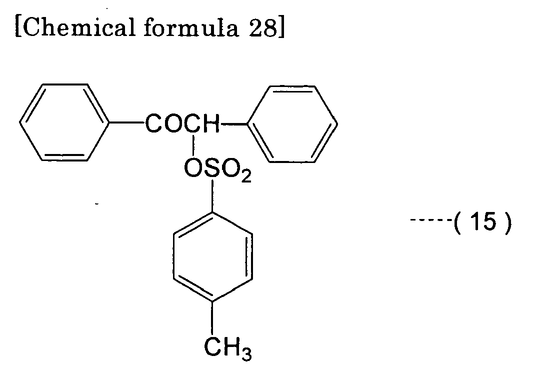

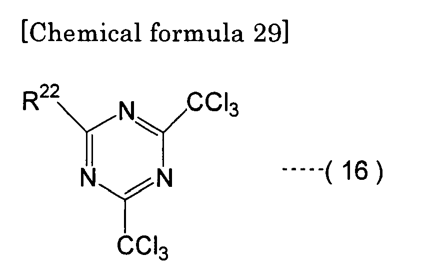

In the formula (16), "R²²" represents a monovalent organic group and examples of "R²²" include a trichloromethyl group, a phenyl group, a *p-*methoxyphenyl group, a dimethoxyphenyl group, a *p*-CH₃SC₆H₄ group, a *p*-chlorophenyl group, a methoxystyryl group, a dimethoxystyryl group, a tri- methoxystyryl group, a propoxystyryl group, a butoxystyryl group, a pentyl- oxystyryl group, a *p*-methoxy-*m*-chlorostyryl group, a 4'-methoxy-1'-naphthyl group and so on.

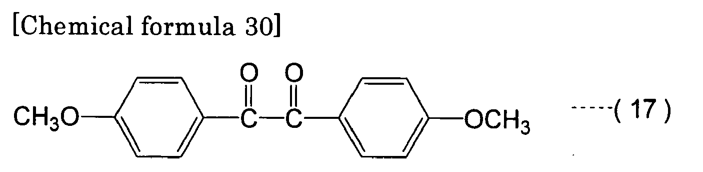

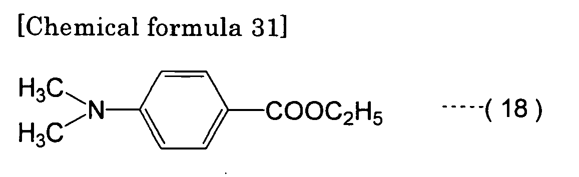

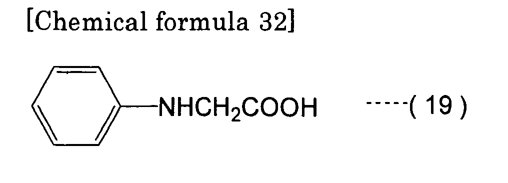

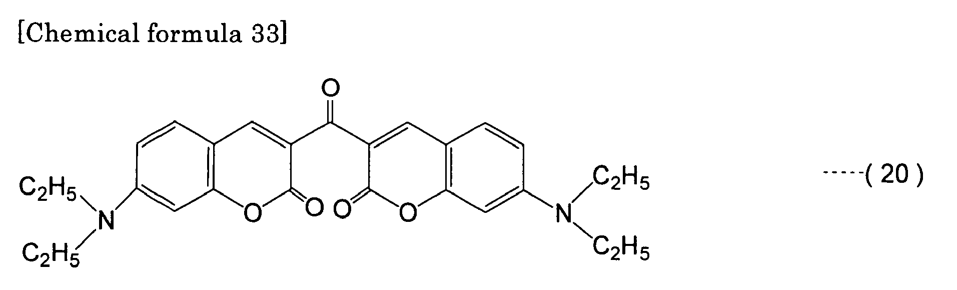

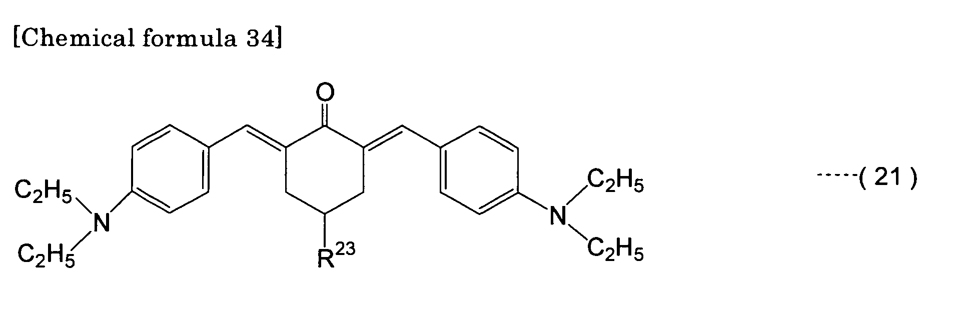

In the formula (21), "R²³" represents a hydrogen atom or a monovalent organic group, and examples of "R²³" include a hydrogen atom, a *tert-* butyl group and so on.

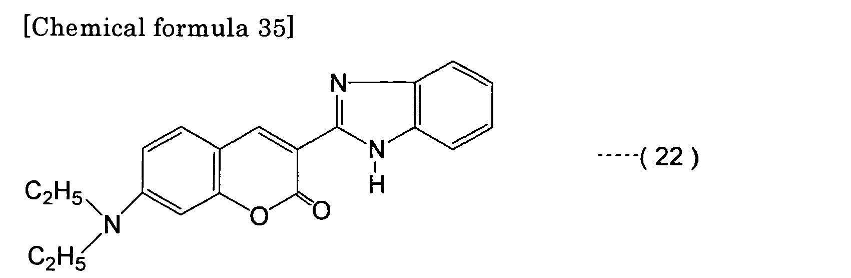

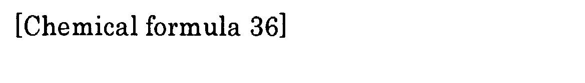

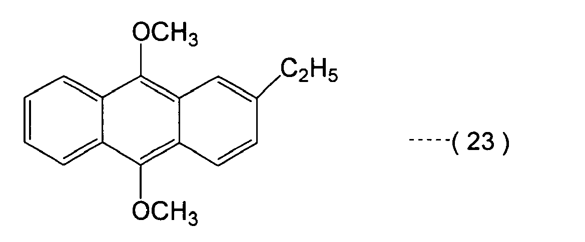

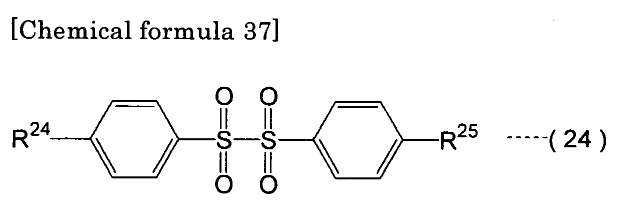

In the formula (24), each of "R²⁴" and "R²⁵" independently represents a hydrogen atom or a monovalent organic group, and examples of "R²⁴" or "R²⁵" include a hydrogen atom, a methyl group and a *tert*-butyl group.

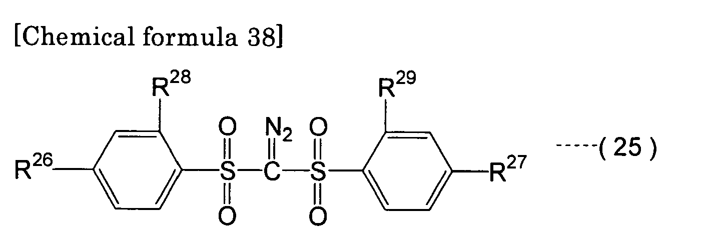

In the formula (25), each of "R²⁶" and "R²⁷" independently represents a hydrogen atom or a monovalent substituted group, and examples of "R²⁶" or "R²⁷" include a hydrogen atom, a chlorine atom, a methyl group and a *tert-* butyl group. Each of "R²⁸" and "R²⁹" independently represents a hydrogen atom or a methyl group.

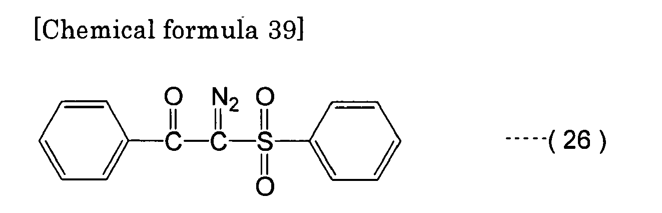

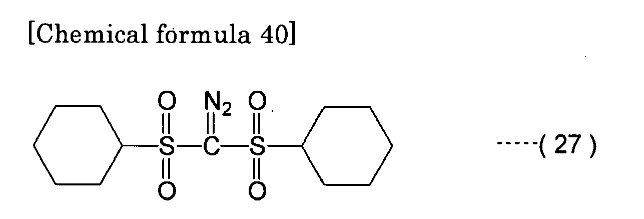

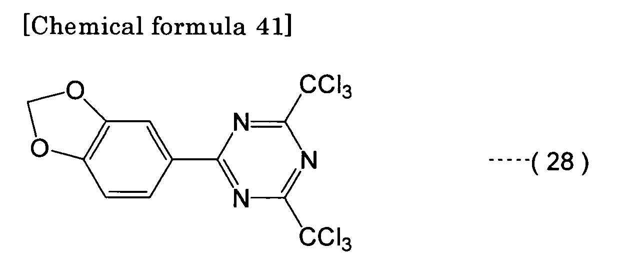

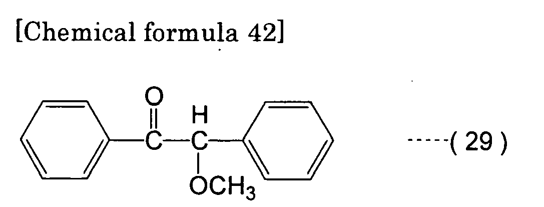

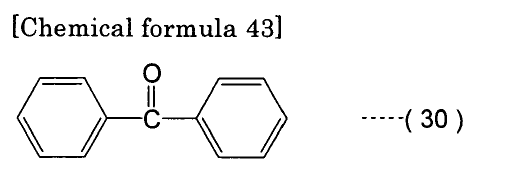

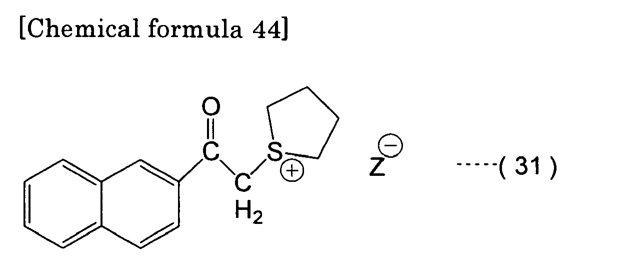

In the formula (31), "Z" is the same as that shown in the formula (13).

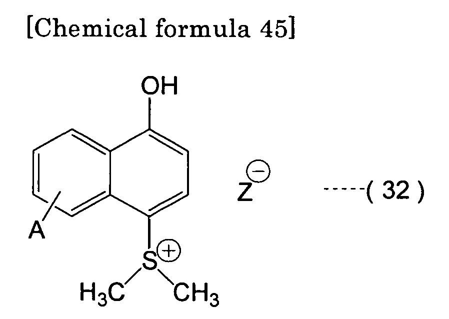

In the formula (32), "Z⁻" is the same as that shown in the formula (13). "A" is a hydrogen atom or a hydroxyl group.

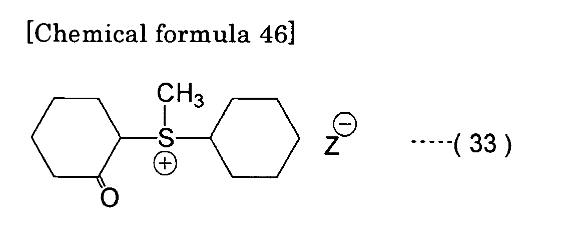

In the formula (33), "Z⁻" is the same as that shown in the formula (13).

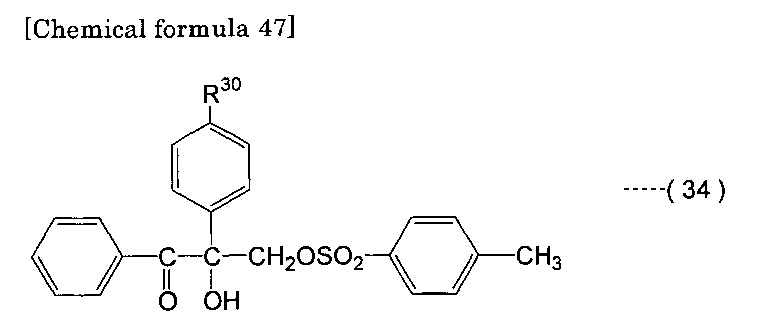

In the formula (34), "R³⁰" represents a hydrogen atom or a -SCH₃ group.

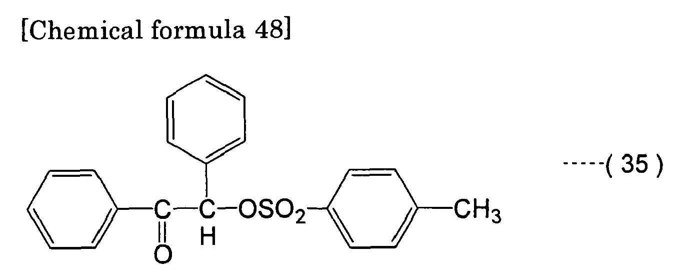

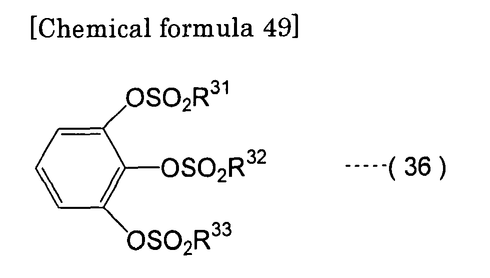

In the formula (36), each of "R³¹" to "R³³" independently represents a monovalent organic group, and is preferably an alkyl group such as a methyl group or an ethyl group.

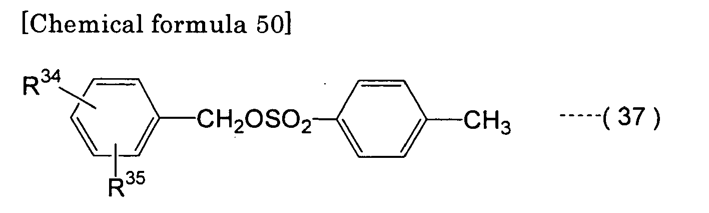

In the formula (37), each of "R³⁴" and "R³⁵" independently represents a hydrogen atom or a NO₂ group.

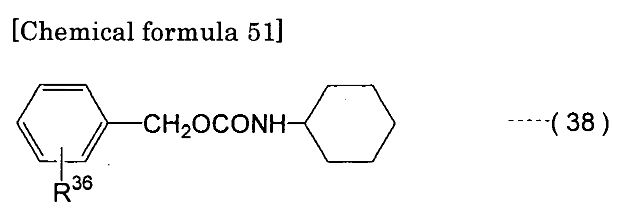

In the formula (38), "R³⁶" represents a hydrogen atom or a NO₂ group.

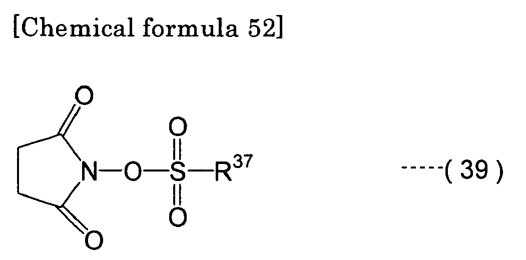

In the formula (39), "R³⁷" represents a methyl, CF₃, phenyl or p-methylphenyl group.

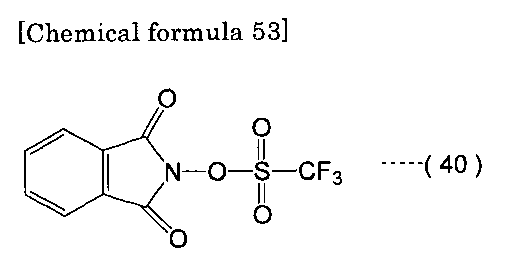

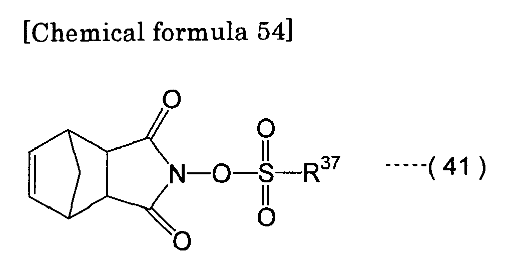

In the formula (41), "R³⁷" is the same as in the formula (39).

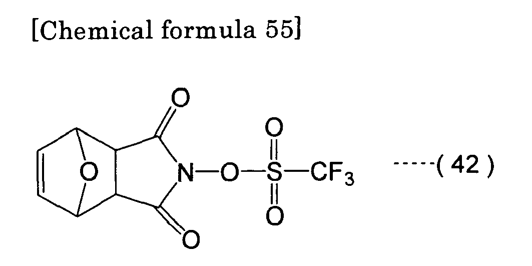

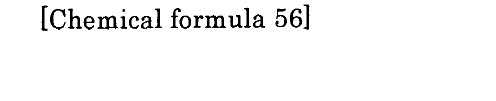

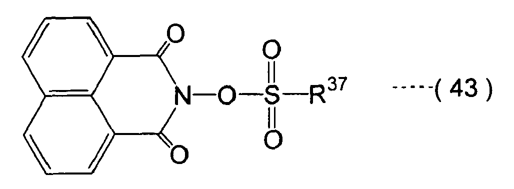

In the formula (43), "R³⁷" is the same as in the formula (39).

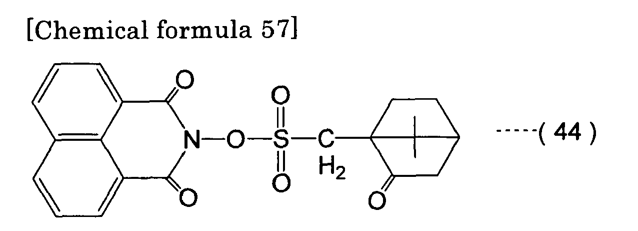

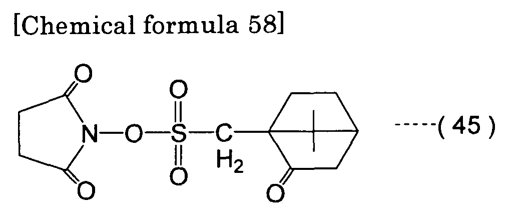

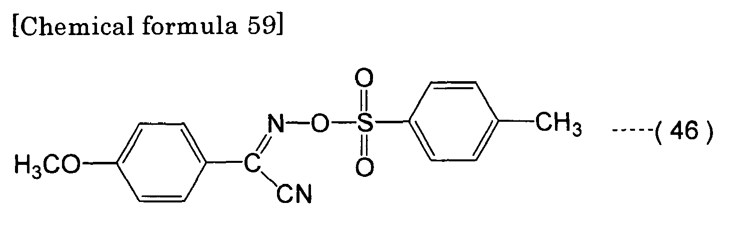

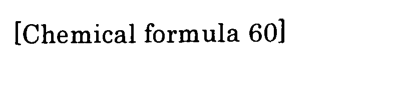

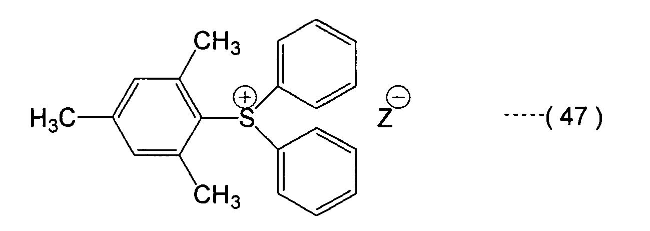

In the formula (47), "Z⁻" is the same as in the formula (13).

As the photo-acid generator, specifically, the photo-acid generator such as IRGACURE series manufactured by Ciba Specialty Chemicals Inc., and products (trade name: BDE, Anisil, BBI-102, TAZ-101, TAZ-104, TAZ-106, TAZ-110 and BC) of Midori Kagaku Co., Ltd. can be widely used. Also, diazodisulfone type or triphenylsulfonium type photo-acid generators manufactured by Wako Pure Chemical Industries, Ltd. may be used.

The content of the photo-acid generator (E) in the positive photosensitive composition of the present invention is preferably 0.5 to 10% by weight and more preferably 1 to 5% by weight based on the total solid amount of the components (A) to (G). These photo-acid generators may be used either singly or in combinations of two or more and may also be used in combination with other photo sensitizer.

The aforementioned resin (F) is at least one alkali-soluble resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinyl caprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine-formaldehyde resin and (10) a ketone resin, and functions as an adhesion improver.

The aforementioned vinylpyrrolidone/vinyl acetate copolymer (1) (hereinafter referred to as a PVP/VA copolymer) is a thermoplastic resin obtained by copolymerizing vinylpyrrolidone with vinyl acetate and has the structure represented by the general formula (48).

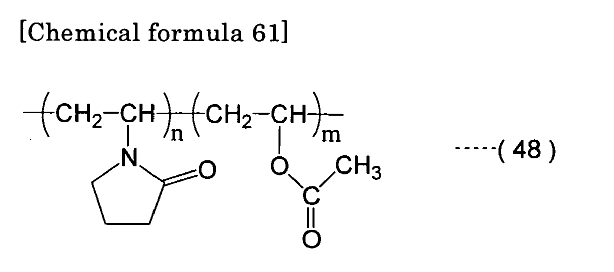

In the formula (48), "n" and "m" denote an integer of 1 or more, respectively. Although there is no particular limitation to the ratio of vinylpyrrolidone to vinyl acetate in the PVP/VA copolymer, the PVP/VA copolymers in which the ratio of vinylpyrrolidone to vinyl acetate is 70/30 to 30/70 are preferable and the PVP/VA copolymers in which the ratio of vinyl- pyrrolidone to vinyl acetate is 50/50 are more preferable.

Although there is no particular limitation to a method for producing the PVP/VA copolymer, a linear random copolymer obtained by free-radical polymerization of vinylpyrrolidone with vinyl acetate is preferable. The molecular weight of the PVP/VA copolymer is preferably 1,000 to 60,000 and more preferably 20,000 to 50,000 although no particular limitation is imposed on it.

The vinylpyrrolidone/dimethylaminoethyl methacrylate copolymer (2) has the structure represented by the following general formula (49).

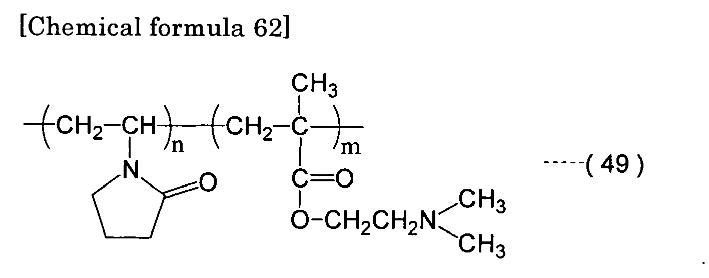

In the formula (49), "n" and "m" denote an integer of 1 or more, respectively.

The aforementioned vinylpyrrolidone/vinyl caprolactam/dimethylaminoethyl methacrylate copolymer (3) is a copolymer of vinylpyrrolidone, vinyl caprolactam and dimethylaminoethyl methacrylate and has the structure represented by the following formula (50).

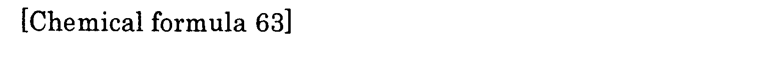

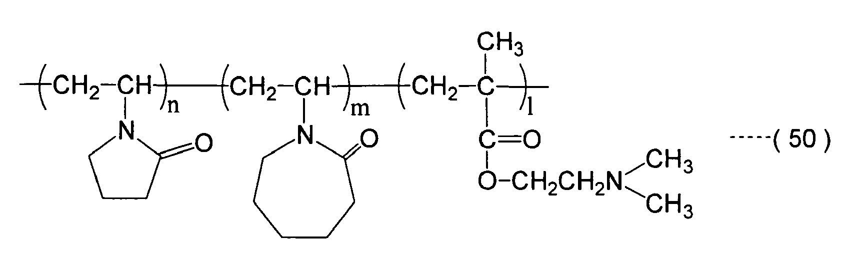

In the formula (50), "n", "m" and "1" denote an integer of 1 or more, respectively.

The aforementioned polyvinyl acetate (4) is a homopolymer of vinyl acetate or a copolymer of vinyl acetate used as a major component and has the structure represented by the following formula (51).

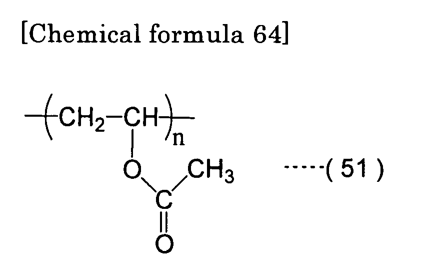

In the formula (51), "n" denotes an integer of 1 or more. As the polyvinyl acetate, for example, SAKNOHOL SN-09T (trade name) manufactured by Denki Kagaku Kogyo Kabushiki Kaisha is preferably used.

The aforementioned polyvinyl butyral (abbreviation: PVB) (5) is a resin obtained by reacting a polyvinyl alcohol with butyl aldehyde to form a butyral compound and has the structure represented by the following formula (52).

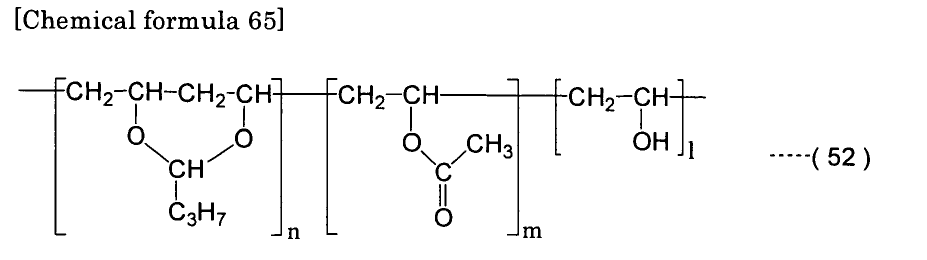

In the formula (52), "n", "m" and "1" denote an integer of 1 or more, respectively. Specific and preferable examples of the polyvinyl butyral include products of Denki Kagaku Kogyo Kabushiki Kaisha, for example, Denka Butyral 5000A and 6000 EP, and products of Sekisui Chemical Co., Ltd. for example, low degree-polymerization type BL-1, BL-2, BL-S and BX-L, middle degree-polymerization type BM-1, BM-2, BM-5 and BM-S and high- degree polymerization type BH-3, BH-S, BX-1, BX-2, BX-5 and BX-55. It is particularly preferable to use BL-S, BM-S and BH-S having solubility in various types of solvent.

The aforementioned polyvinyl formal (PVFM) (6) is a resin that has high electric insulation and is represented by the following formula (53).

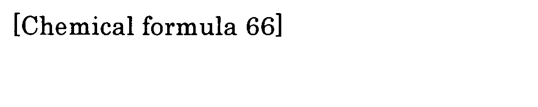

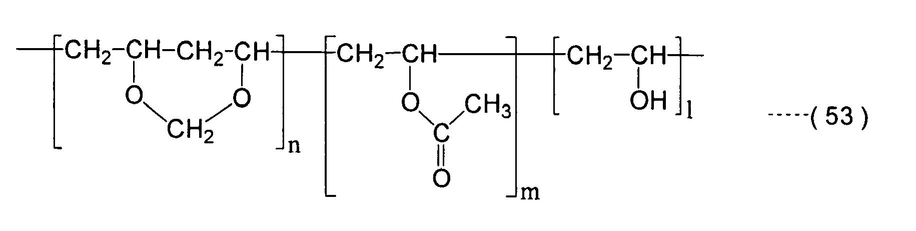

In the formula (53), "n", "m" and "1" denote an integer of 1 or more, respectively. Although no particular limitation is imposed on a method for producing the polyvinyl formal, for example, a polyvinyl acetate is dissolved in acetic acid, formaldehyde and sulfuric acid are added to the solution to run a saponification reaction and a formal reaction simultaneously, and dilute sulfuric acid is added to the reaction solution to precipitate a polyvinyl formal, followed by a solvent recovery step, washing step and drying step, to obtain a product.

As the aforementioned terpene phenolic resin (7), a wide range of conventionally known resins may be used. Specific and preferable examples of the resin include TAMANOL 803L and 901 (trade name, manufactured by Arakawa Chemical Industries, Ltd.)

As the aforementioned alkylphenolic resin (8), a wide range of conventionally known resins may be used. Specific and preferable examples of the resin include TAMANOL 520S, 521, 526, 586 and 572S (trade name, manufactured by Arakawa Chemical Industries, Ltd.).

The aforementioned melamine-formaldehyde resin (9) is resin obtained by an addition-condensation reaction of melamine and formaldehyde. A wide range of known melamine-formaldehyde resins may be used as this melamine-formaldehyde resin. Specifically, it is preferable to use, for example, BANCEMINE SM-960 (trade name) manufactured by Harima Chemicals, Inc.

As the ketone resin (10), known ketone resins may be used without any particular limitation. For example, the ketone resin may be obtained by reacting ketones with formaldehyde according to the known method. Examples of the ketones include methyl ethyl ketone, methyl isobutyl ketone, acetophenone, cyclohexanone, and methyl cyclohexanone. Particularly, cyclohexanone and acetophenone are preferable. As the ketone resin, cyclo- hexanone type ketone resins represented by the following formula (54) and acetophenone type ketone resins having the structure represented by the following formula (55) are preferable.

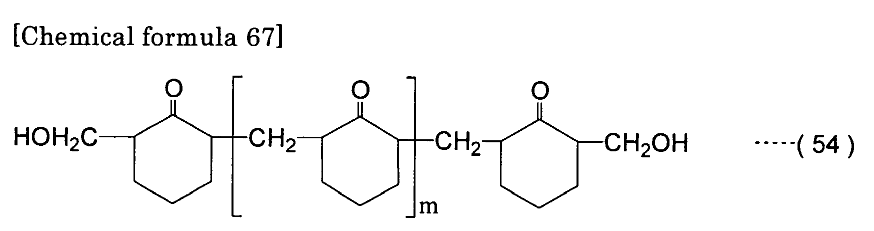

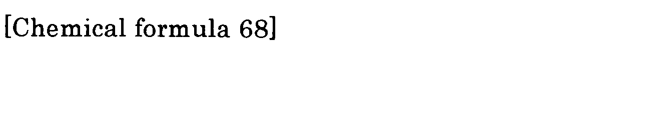

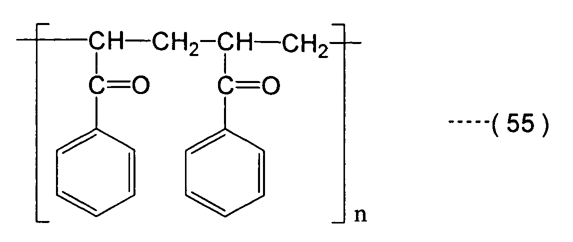

In the formulae (54) and (55), "m" and "n" denote an integer of 1 or more, respectively.

The content of the resin (F) in the positive photosensitive composition of the present invention is preferably 1 to 40% by weight and more preferably 5 to 30% by weight based on the total solid amount of the components (A) to (G).

As the aforementioned triarylmethane dye (G), a wide range of conventionally known triarylmethane type color dyes may be used. Specifically, Methyl Violet, Crystal Violet, Victoria Blue B, Oil Blue 613 (trade name, manufactured by Orient Chemical Industries, Ltd.) and their derivatives are preferable as the dye (F). These triarylmethane dyes may be used either singly or in combinations of two or more.

The use of color dyes has the effect that when a pattern is made by development, pinholes and dusts on the surface of the photosensitive film can be clearly recognized and it is therefore easy to carry out application work using a retouching liquid (Opaque). The higher the concentration of the dye is, the more easily these pinholes and dusts can be seen, which is preferable. Incidentally, because this retouching operation is not allowed in semiconductor industries, an operation is carried out in a clean room, whereas in printing industries and industries relevant to electronic parts, the retouching operation is carried out to remake inferior products.

The content of the triarylmethane dye (G) in the positive photosensitive composition of the present invention is preferably 0.1 to 10% by weight and more preferably 1 to 4% by weight based on the total solid amount of the components (A) to (G).

The positive photosensitive composition of the present invention may comprise, besides the aforementioned components, if necessary, various additives such as coloring agents such as other pigments or dyes, a photo sensitizer, a developing promoter, an adhesion-modifying agent and a coating improving agent. As the developing promoter, for example, dicarboxylic acid, amines or glycols is preferably added in a small amount.

The positive photosensitive composition of the present invention is usually used in the form of a solution obtained by dissolving the composition in a solvent. The proportion by weight of the solvent to be used is generally in a range from 1 to 20 times the total solid content of the photosensitive composition.

As the solvent, any solvent may be used without any particular limitation insofar as it has enough solubility to components used and imparts good coatability, and a cellosolve type solvent, propylene glycol type solvent, ester type solvent, alcohol type solvent, ketone type solvent or highly polar solvent may be used. Examples of the cellosolve type solvent include methyl cellosolve, ethyl cellosolve, methyl cellosolve acetate and ethyl cellosolve acetate. Examples of the propylene glycol type solvent include propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether. Examples of the ester type solvent include butyl acetate, amyl acetate, ethyl butyrate, butyl butyrate, diethyl oxalate, ethyl pyruvate, ethyl-2-hydroxybutyrate, ethyl acetoacetate, methyl lactate, ethyl lactate and methyl-3-methoxy- propionate. Examples of the alcohol type solvent include heptanol, hexanol, diacetone alcohol and furfuryl alcohol. Examples of the highly polar solvent include ketone type solvents such as cyclohexanone and methyl amyl ketone, dimethylformamide, dimethylacetamide and N-methyl-pyrrolidone. Examples other than the above include acetic acid, mixtures of these solvents, and, further, solvents obtained by adding an aromatic hydrocarbon to these solvents.

The positive photosensitive composition of the present invention may be produced in the following manner. Usually, the above each component is dissolved in a solvent such as a cellosolve type solvent or propylene glycol type solvent to make a solution, which is then applied to the surface of the support, specifically, the copper or copper sulfate plating surface of the plate- making roll for gravure printing use and naturally dried. Then, the roll is rotated at high speed so that the surface of the plate-making roll goes through the air. A mass effect due to centrifugal force in the photosensitive film and the condition of the neighborhood of the surface placed under a slightly negative pressure allow the concentration of residual solvents to be reduced to 6% or less, to thereby make a positive photosensitive film with the photo- sensitive composition layer being formed on the surface of the support.

The process of producing the positive photosensitive composition of the present invention is not particularly limited. It is preferred to apply heating treatment to the composition wherein the respective components are compounded. The heating treatment makes it possible to ripen and stabilize the positive photosensitive composition so as to improve the stability on standing, the reproducibility, and others remarkably.

As a coating method, meniscus coating, fountain coating, dip coating, rotary coating, roll coating, wire bar coating, air-knife coating, blade coating and curtain coating may be used. The thickness of the coating film is in a range preferably from 1 to 6 µm and more preferably 3 to 5 µm.

As the light source used for image exposure of the positive photosensitive composition layer, a semiconductor laser and a YAG laser which emit infrared laser rays having a wavelength of 700 to 1,100 nm are preferable. Besides the above, a solid laser such as a ruby laser and LED may be used. The intensity of the laser light source is designed to be 2.0 x 10⁶ mJ/scm² or more and particularly preferably 1.0 x 10⁷ mJ/scm² or more.

As a developing solution used for the photosensitive film formed by using the positive photosensitive composition of the present invention, a developing solution comprising an inorganic alkali (e.g., salts of Na or K) or an organic alkali (e.g., TMAH (Tetra Methyl Ammonium Hydroxide) or choline) is preferable.

The development is carried out at usually about 15 to 45°C and preferably 22 to 32°C by dipping development, spray development, brush development, ultrasonic development and so on.

### EXAMPLES:

The present invention will be more specifically described by way of working examples hereinafter. Of course, however, these examples are illustrative, and should not be interpreted to be restrictive.

### (Example 1)

The ingredients and proportions shown in Table 1 were used to prepare a composition. The resultant composition was heated to 40°C to stabilize the positive photosensitive composition. Thereafter, this was used as a test sensitizing solutio.

**[Table 1]**

| | Ingredients | Proportion (parts by weight) |
|---|---|---|
| Component (A) | Resin A1 | 100 |
| Component (B) | Amine compound 1 | 0.3 |
| Component (C) | IR-photosensitive dye C1 | 3 |
| Component (D) | Dissolution inhibitor 1 | 2 |
| Component (E) | Photo-acid generator 1 | 2 |
| Component (F) | Resin F1 | 8 |
| Component (G) | Color dye G1 | 2 |
| Solvent | PM | 590 |
| | IPA | 737 |
| | MEK | 589 |

Each component in Table 1 is as follows.
Resin A1: SMA 1440 (manufactured by SARTOMER Company, Inc., a partial ester of styrene/maleic anhydride copolymer with butyl cellosolve)
Amine compound 1: N-ethylethanolamine
IR-photosensitive dye C1: Infrared absorbing dye represented by the above formula (3).
Dissolution inhibitor 1: TrisP-PA (manufactured by Honshu Chemical Industry Co., Ltd., compound represented by the above formula (2)).
Photo-acid generator 1: IRGACURE 250 (manufactured by Ciba Specialty Chemicals Inc., compound represented by the above formula (5)).
Resin F1: PVP/VA copolymer (copolymer of vinylpyrrolidone and vinyl acetate, vinylpyrrolidone/vinyl acetate: 50/50, molecular weight: 46,000, glass transition temperature: 96°C).
Color dye G1: Oil Blue 613 (manufactured by Orient Chemical Industries, Ltd., Color Index (C.I.) No. 42595).
- PM:: Propylene glycol monomethyl ether.
- IPA:: Isopropyl alcohol.
- MEK:: Methyl ethyl ketone.

The following experiments were made using the obtained test sensitizing solutions. The experiment was carried out under the condition that laboratory was maintained at a temperature of 25°C and the humidity shown in Table 2. A plate-making roll of φ 200 mm which used iron as base material of the roll and was plated with copper sulfate and mirror-polished was rotated at 25 r.p.m. with the both ends thereof being chucked by a fountain coating apparatus (apparatus equipped with a dehumidifier and a humidifier where the humidity can be controlled desirably) and thoroughly wiped and cleaned by a wiping cloth. It is to be noted that the fountain coating apparatus has the ability to avoid the phenomenon that solvents in the positive photosensitive composition are vaporized to change the ratio of these solvents during coating.

Thereafter, a pipe allowing the test sensitizing solution to be overflowed from the top thereof was positioned at one end of the plate-making roll so as to form a gap of about 500 µm from the roll. The pipe was moved from one end to the other end of the roll with making the test sensitizing solution overflow in an amount necessary for coating, to apply the test sensitizing solution uniformly to the roll by a spiral scan method, and the rotation was continued at 25 r.p.m. for 5 minutes after the application was finished and then stopped.

Five minutes were taken for waiting until oozing of a liquid was observed, with the result that the generation of the oozing of a liquid could not be observed with the naked eye. Then, the film thickness was measured, to find that there was no difference in thickness between the lower surface part and upper surface part of the roll. It was thus confirmed that the photosensitive film dried to a solid condition permitting no oozing of a liquid was set.

In succession, the test roll was rotated at 100 r.p.m. for 20 minutes and then stopped to measure the concentration of residual solvents in the photosensitive film, to find that the concentration was 2.9%.

Then, the test roll was fit to an exposure apparatus (manufactured by Think Laboratory) mounted with a high-power semiconductor laser head of CreoScitex Co., Ltd. and then irradiated with laser light having a wavelength falling in the infrared region to print a positive image. Next, the test roll was fit to a developing machine and was developed with rotating the roll and lifting the developing tank until no residue was observed, followed by washing with water. As the developing solution, 4.2% KOH (25°C) was used. The resulting resist image was evaluated by a microscope. The results are shown in Table 2.

**[Table 2]**

| | Humidity (%) | Adhesion | Sensitivity (MJ/cm²) | Development (seconds) | Rate of residual film | Image | Resolution of edges | Latitude of develoment |
|---|---|---|---|---|---|---|---|---|
| Example 1-1 | 35 | ⊚ | 20 | 75 | 71 | ⊚ | ⊚ | ⊚ |
| Example 1-2 | 45 | ⊚ | 220 | 75 | 77 | ⊚ | ⊚ | ⊚ |
| Example 1-3 | 55 | ⊚ | 220 | 75 | 74 | ⊚ | ⊚ | ⊚ |

The methods of evaluation in Table 2 are as follows.
1) Resolution of edges
   Using the resolution test pattern shown in Fig. 1, whether or not the edges of 7.9 µm line of a check and grating was sharp. In the table, "⊚" shows a good result and shows that the sample passed the resolution test and "×" shows that no image was formed and plate-making could not be attained and the sample did not pass the resolution test.
2) Latitude of development
   The latitude of development was measured using a cellar (device capable of automatically measuring the opening ratio of dots) manufactured by Dai Nippon Printing Co., Ltd. A test was made in which the number of developing processes was increased (three times in the Example). In the case where the cell area falls in 60 to 75 µm² by exposure to light of 7.9 µm x 7.9 µm, this cell area falls in the allowable range of printing density and shows that the latitude of development is good, which is expressed as "⊚" in the table. In the case where the cell area is out of the allowable range of printing, the latitude of development is expressed as "×" in the table.
3) Adhesion
   The tesa test: in a cross-cut adhesion test using a DIN EN ISO 2409 tesa tape, the case where 100 squares all remain is defined as "⊚", the case where squares less than 20% are peeled is defined as "O" and the case where 20% or more of squares are peeled is defined as "×".
4) Sensitivity
   Exposure amount was varied to find one at which an image pattern was reproduced most exactly to decide the sensitivity. As the exposure apparatus, a thermal imaging head manufactured by Creo Co., Ltd. was used.
5) Development
   The development time taken until no residue was found was measured.
6) The rate of residual film
   Film thicknesses before and after development were measured using FILMETRICS Thin Film Analyzer F20 (manufactured by Filmetrics Co.) which calculate thickness of coating film to calculate the rate of residual film.
7) Image
   The reproducibility of an original image was evaluated. ⊚: Very good, ×: Very inferior, -: An image disappeared by development.

The test pattern of the sensitizing solution and measuring positions are shown in Fig. 1. Check items and measuring method for the measuring positions in Fig. 1 are shown in Table 3.

**[Table 3]**

| Measuring Position | Checking item | Photography | Measurement of area (Cellzoh) |
|---|---|---|---|
| ① | Presence or absence of developing residue | - | - |
| ② | 1 Pixel check | ○ | - |
| ③ | 1 Pixel highlight | ○ | ○ |
| ④ | 7 µm grating | ○ | ○ |

As shown in Table 2, the positive photosensitive composition of Example 1 made it possible to carry out good development to obtain a sharp pattern freed of residues in about 70 seconds in the condition of a room temperature of 25°C and humidity of 35 to 55%. Also, good latitude of development was obtained.

The experiment was also made in the case of using a copper surface or an aluminum surface in place of the copper sulfate plating surface. In all of these cases, the same satisfactory results as in Example 1 were obtained. In the case of the aluminum surface, a especially wide latitude of development was obtained.

Furthermore, experiments were performed about the test sensitizing solution after one day, one month and two months from the production. In each of the experiments, good results were obtained. Experiments were performed about the test sensitizing solution subjected to heating treatment at 50°C before the experiments. Good results were obtained in the same manner as in Example 1, which was carried out at the room temperature.

### (Examples 2 to 6)

The same experiments as in Example 1-2 were made except that the components (C) and (G) in the compositions were altered as shown in Table 4. The measurement was made under humidity of 45%. The results are shown in Table 4.

**[Table 4]**

| | Component (C) proportion | Component (G) proportion | Adhesion | Sensitivity (mJ/cm2) | Development (seconds) | Rate of residual film (%) | Image | Resolution of edges | Latitude of development |
|---|---|---|---|---|---|---|---|---|---|
| Example 2 | Dye C2 1 | Dye G2 6 | ⊚ | 220 | 75 | 73 | ⊚ | ⊚ | ⊚ |
| Example 3 | Dye C3 3 | Dye G3 3 | ⊚ | 220 | 75 | 75 | ⊚ | ⊚ | ⊚ |
| Example 4 | Dye C4 4 | Dye G4 4 | ⊚ | 220 | 75 | 73 | ⊚ | ⊚ | ⊚ |
| Example 5 | Dye C5 6 | Dye G1 1 | ⊚ | 220 | 75 | 77 | ⊚ | ⊚ | ⊚ |
| Example 6 | Dye C6 2 | Dye G2 2 | ⊚ | 220 | 75 | 75 | ⊚ | ⊚ | ⊚ |

In Table 4, the dyes C2 to C6 and dyes G2 to G4 are as follows. Each proportion of the components (C) and (G) are shown by parts by weight when the proportion of the component (A) to be compounded is set to 100 parts by weight.
Dye C2: IR-B (manufactured by SHOWA DENKO K.K., infrared absorbing dye represented by the above formula (9)).
Dye C3: IR-T (manufactured by SHOWA DENKO K.K., infrared absorbing dye represented by the above formula (10)).
Dye C4: IR-2MF (manufactured by SHOWA DENKO K.K., infrared absorbing dye represented by the above formula (11)).
Dye C5: IR-13F (manufactured by SHOWA DENKO K.K., infrared absorbing dye represented by the above formula (12)).
Dye C6: NK-2014 (manufactured by Hayashibara biochemical laboratories Inc., infrared absorbing dye represented by the following formula (56)).

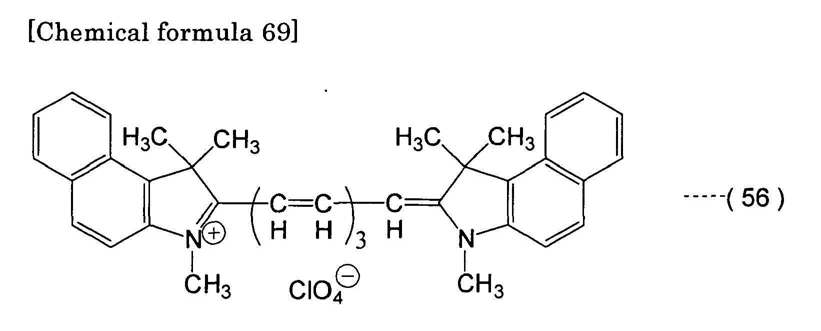

Dye G2: AIZEN METHYL VIOLET BB SPECIAL (C. I. Basic Violet 1, No. 42535, manufactured by Hodogaya Chemical Co., Ltd.)
Dye G3: AIZEN CRYSTAL VIOLET (C. I. Basic Violet 3, No. 42555, manufactured by Hodogaya Chemical Co., Ltd.)
Dye G4: AIZEN VICTORIA BLUE BH (C. I. Basic Blue 26, No. 44045, manufactured by Hodogaya Chemical Co., Ltd.)

### (Examples 7 to 16)

Experiments were performed in the same way as in Example 1-2 except that the component (A) in the composition was changed as shown in Table 5. The results are shown also in Table 5.

**[Table 5]**

| | Component (A) | Adhesion | Sensitivity (mJ/cm²) | Development (seconds) | Rate of residual film (%) | Image | Resolution of edges | Latitude of development |
|---|---|---|---|---|---|---|---|---|
| Example 7 | Resin A2 | ⊚ | 220 | 75 | 76 | ⊚ | ⊚ | ⊚ |
| Example 8 | Resin A3 | ⊚ | 220 | 75 | 77 | ⊚ | ⊚ | ⊚ |
| Example 9 | Resin A4 | ⊚ | 220 | 75 | 75 | ⊚ | ⊚ | ⊚ |
| Example 10 | Resin A5 | ⊚ | 220 | 75 | 73 | ⊚ | ⊚ | ⊚ |
| Example 11 | Resin A6 | ⊚ | 220 | 75 | 72 | ⊚ | ⊚ | ⊚ |
| Example 12 | Resin A7 | ⊚ | 220 | 75 | 75 | ⊚ | ⊚ | ⊚ |
| Example 13 | Resin A8 | ⊚ | 220 | 75 | 78 | ⊚ | ⊚ | ⊚ |
| Example 14 | Resin A9 | ⊚ | 220 | 75 | 76 | ⊚ | ⊚ | ⊚ |
| Example 15 | Resin A10 | ⊚ | 220 | 75 | 75 | ⊚ | ⊚ | ⊚ |
| Example 16 | Resin A11 | ⊚ | 220 | 75 | 76 | ⊚ | ⊚ | ⊚ |

In Table 5, the proportion of the component (A) was the same as in Example 1, and resins A2 to A11 were as follows.
Resin A2: SMA 17352 (partially esterified product of a styrene/maleic anhydride copolymer with isopropanol/cyclohexanol, manufactured by Sartomer Company, Inc.)
Resin A3: SMA 2624 (partially esterified product of a styrene/maleic anhydride copolymer with n-propanol, manufactured by Sartomer Company, Inc.)
Resin A4: SMA 3840 (partially esterified product of a styrene/maleic anhydride copolymer with isooctanol, manufactured by Sartomer Company, Inc.)
Resin A5: OXYLAC SH-101 (copolymer of styrene/maleic acid half-ester, manufactured by Nippon Shokubai Co., Ltd.)
Resin A6: copolymer of acrylic acid, methyl methacrylate, and styrene (acid value: 98, weight-average molecular weight: 21000, and base monomer ratio: acrylic acid/methyl methacrylate/styrene = 1:1:1)
Resin A7: maleic acid polymer (acid value: 300, and weight-average molecular weight: 10000)
Resin A8: acrylic acid polymer (acid value: 100, and weight-average molecular weight: 25000)
Resin A9: OXYLAC SH-101 derivative (styrene/maleic acid copolymer to which glycidyl methacrylate is added, acid value: 80)
Resin A10: maleic anhydride polymer (acid value: 495, styrene/maleic anhydride ratio: 1:1, weight-average molecular weight: 5500, and glass transition temperature: 155°C)
Resin A11: Resin A6 to which glycidyl-methacrylate is added.

### (Examples 17 to 21)

Experiments were performed in the same way as in Example 1-2 except that the component (B) in the composition was changed as shown in Table 6. The results are also shown in Table 6.

**[Table 6]**

| Example No. | Component (B) proportion | Adhesion | Sensitivity (mJ/cm²) | Development (seconds) | Rate of residual film (%) | Image | Resolution of edges | Latitude of development |
|---|---|---|---|---|---|---|---|---|
| 17 | Amine compound 2 0.4 | ⊚ | 220 | 75 | 75 | ⊚ | ⊚ | ⊚ |
| 18 | Amine compound 3 0.2 | ⊚ | 220 | 75 | 73 | ⊚ | ⊚ | ⊚ |
| 19 | Amine compound 4 0.3 | ⊚ | 220 | 75 | 77 | ⊚ | ⊚ | ⊚ |
| 20 | Amine compound 5 0.5 | ⊚ | 220 | 75 | 72 | ⊚ | ⊚ | ⊚ |
| 21 | Amine compound 6 0.3 | ⊚ | 220 | 75 | 70 | ⊚ | ⊚ | ⊚ |

In Table 6, amine compounds 2 to 6 are as follows. The proportion of the component (B) is a value of parts by weight when the proportion of the component (A) is regarded as 100 parts by weight.
Amine compound 2: N,N-diethylisopropanolamine
Amine compound 3: N,N-dimethylethanolamine
Amine compound 4: N-methyldiethanolamine
Amine compound 5: morpholine
Amine compound 6: hydroxyethylpiperidine

### (Examples 22 to 31)

Experiments were performed in the same way as in Example 1-2 except that each resin shown in Table 7 was used, as the component (F), instead of the resin F1. The results are also shown in Table 7.

**[Table 7]**

| Example No. | Component(F) parts by weight | Adhesion | Sensitivity (mJ/cm²) | Development (seconds) | Rate of residual film (%) | Image | Resolution of edges | Latitude of development |
|---|---|---|---|---|---|---|---|---|
| 22 | Resin F2 2 | ⊚ | 220 | 75 | 75 | ⊚ | ⊚ | ⊚ |
| 23 | Resin F3 5 | ⊚ | 220 | 75 | 70 | ⊚ | ⊚ | ⊚ |
| 24 | Resin F4 10 | ⊚ | 220 | 75 | 73 | ⊚ | ⊚ | ⊚ |
| 25 | Resin F5 8 | ⊚ | 220 | 75 | 76 | ⊚ | ⊚ | ⊚ |
| 26 | Resin F6 20 | ⊚ | 220 | 75 | 72 | ⊚ | ⊚ | ⊚ |
| 27 | Resin F7 30 | ⊚ | 220 | 75 | 71 | ⊚ | ⊚ | ⊚ |
| 28 | Resin F8 10 | ⊚ | 220 | 75 | 75 | ⊚ | ⊚ | ⊚ |
| 29 | Resin F9 10 | ⊚ | 220 | 75 | 77 | ⊚ | ⊚ | ⊚ |
| 30 | Resin F10 10 | ⊚ | 220 | 75 | 71 | ⊚ | ⊚ | ⊚ |
| 31 | Resin F11 8 | ⊚ | 220 | 75 | 74 | ⊚ | ⊚ | ⊚ |

In Table 7, resins F2 to F11 are as follows.
Resin F2: GAFQUAT 734 (vinylpyrrolidone/dimethylaminoethyl methacrylate copolymer, manufactured by ISP Inc.)
Resin F3: GAFFIX VC-713 (vinylpyrrolidone/vinylcaprolactam/dimethylaminoethyl 1 methacrylate terpolymer, manufactured by ISP Inc.)
Resin F₄: SACNOL SN-09T (polyvinyl acetate, manufactured by DENKI KAGAKU KOGYO KABUSHIKI KAISHA)
Resin F5: DENKA BUTYRAL #3000 (polyvinyl butyral, manufactured by DENKI KAGAKU KOGYO KABUSHIKI KAISHA)
Resin F6: VINYLEC K type (polyvinyl formal, manufactured by Chisso Corporation)
Resin F7: TAMANOL 803L (terpene phenol resin, manufactured by Arakawa Chemical Industries, Ltd.)
Resin F8: TAMANOL 520S (alkylphenol resin, manufactured by Arakawa Chemical Industries, Ltd.)
Resin F9: BANCEMINE SM-960 (melamine/formaldehyde resin, manufactured by Harima Chemicals, Inc.)
Resin F10: HIGHLAC 111 (cyclohexane resin, manufactured by Hitachi Chemical Co., Ltd.)
Resin F11: HIGHLAC 110H (acetophenone resin, manufactured by Hitachi Chemical Co., Ltd.)

### (Example 32)

Experiments were performed in the same way as in Example 1-2 except that the component (D) was not compounded. The results are shown in Table 8.

### (Example 33)

Experiments were performed in the same way as in Example 1-2 except that the component (E) was not compounded. The results are shown in Table 8.

### (Example 34)

Experiments were performed in the same way as in Example 1-2 except that the component (F) was not compounded. The results are shown in Table 8.

### (Example 35)

Experiments were performed in the same way as in Example 1-2 except that the components (D) to (G) were not compounded. The results are shown in Table 8.

**[Table 8]**

| Example No. | Adhesion | Sensitivity (mJ/cm²) | Development (seconds) | Rate of rsidual film (%) | Image | Resolution of edges | Latitude of development |
|---|---|---|---|---|---|---|---|
| 32 | ⊚ | ⊚ | 220 | 73 | 75 | ⊚ | ⊚ |
| 33 | ⊚ | ⊚ | 220 | 76 | 75 | ⊚ | ⊚ |
| 34 | ⊚ | ⊚ | 220 | 74 | 75 | ⊚ | ⊚ |
| 35 | ⊚ | ⊚ | 220 | 77 | 75 | ⊚ | ⊚ |

### (Comparative Examples 1 to 3)

Experiments were performed in the same way as in Example 1-2 except that the combination of the positive photosensitive composition was changed as shown in Table 9. The results are shown in Table 10.

**[Table 9]**

| | | Comparative Example 1 | Comparative Example 2 | Comparative Example 3 |
|---|---|---|---|---|
| Novolak resin | | 100 | 100 | 100 |
| IR-phptosensitive dye C1 | | 1 | 1 | 1 |
| Organotitanium compound | | - | 2 | - |
| Imidazole silane | | - | - | 2 |
| Solvent | PM | 800 | 800 | 800 |
| | IPA | 800 | 800 | 800 |
| | MEK | 600 | 600 | 600 |

In Table 9, the IR-photosensitive dye C1 and the solvents are the same as in Table 1, and the other components are as follows. Novolak resin: PR-NMD-100 (manufactured by SUMITOMO BAKELITE Co., Ltd.)
Organotitanium compound: ORGATICS TA-10 (titanium alkoxide), manufactured by Matsumoto Chemical Industry Co., Ltd.
Imidazole silane: silane coupling agent having a structure of the following formula (57). In the formula (57), R⁴¹ to R⁴⁴ respectively represent an alkyl group, and "n" denotes an integer of 1 to 3.

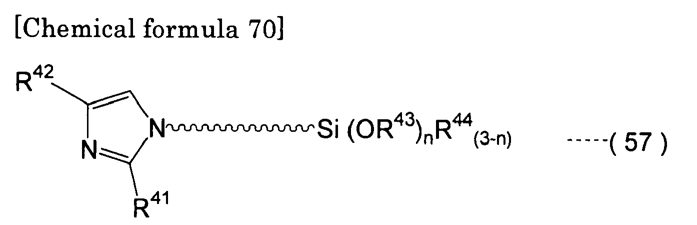

**[Table 10]**

| | Adhesion | Sensitivity (mJ/cm²) | Development (seconds) | Rate of residual film (%) | Image | Resolution of edges | Latitude of development |
|---|---|---|---|---|---|---|---|
| Comparative Example 1 | ○ | 150 | 60 | 0 | - | × | × |
| Comparative Example 2 | ○ | 150 | 60 | 0 | - | × | × |
| Comparative Example 3 | ○ | 150 | 60 | 0 | - | × | × |

In Comparative Examples 1 to 3 as shown in Table 10, the image disappeared after development and no latitude of development was obtained at all.

### Capability of Exploitation in Industry:

The positive photosensitive composition of the present invention is preferably used to form a positive photosensitive film on the copper sulfate surface of a plate-making roll for gravure printing. However, no particular limitation to the material on which the composition of the present invention is applied. Even if the composition is applied to plates of metals such as aluminum, zinc and steel, metal plates on which aluminum, zinc, copper, iron, chromium, nickel, or the like is plated or deposited, paper coated with a resin, paper coated with a metal foil such as an aluminum foil, plastic films, hydrophilically treated plastic films, glass plates, and so on, it has high adhesion at low temperatures, ensuring that high sensitivity is obtained.

The positive photosensitive composition of the present invention is, therefore, preferably used for photosensitive planographic printing plates, proofs for simplified proofing printing, wiring boards, gravure copper etching resists, color-filter resists used to produce flat displays, photoresists for producing LSI, a member related for forgery prevention and the like.

## Claims

1. A positive photosensitive composition, for which no burning is necessary, comprising:
(A) a high molecular substance having at least one carboxyl group and/or at least one acid anhydride group in a molecule thereof,
(B) an amine compound, and
(C) a photo-thermal conversion material that absorbs infrared rays from an image exposure light source to convert the rays to heat.

2. The positive photosensitive composition according to claim 1,
wherein the high molecular substance (A) is at least one high molecular compound selected from the group consisting of a polymer obtained from an unsaturated compound (a1) having at least one carboxyl group and/or at least one carboxylic acid anhydride group, and a copolymer obtained from the unsaturated compound (a1) and a compound (a2) copolymerizable with the unsaturated compound.

3. The positive photosensitive composition according to claim 2,
wherein the unsaturated compound (a1) is at least one compound selected from the group consisting of maleic acid, (meth)acrylic acid, and derivatives thereof.

4. The positive photosensitive composition according to any one of claims 1 to 3, wherein the high molecular substance (A) is at least one polymer selected from the group consisting of a maleic acid polymer, a (meth)acrylic acid polymer, a styrene/maleic acid copolymer, and derivatives thereof.

5. The positive photosensitive composition according to claim 4,
wherein the high molecular substance (A) is a styrene/maleic acid copolymer obtained by reaction of a styrene/maleic anhydride copolymer with a compound having a hydroxyl group.

6. The positive photosensitive composition according to any one of claims 1 to 5,
wherein the high molecular substance (A) is a polymer represented by the following formula (1): 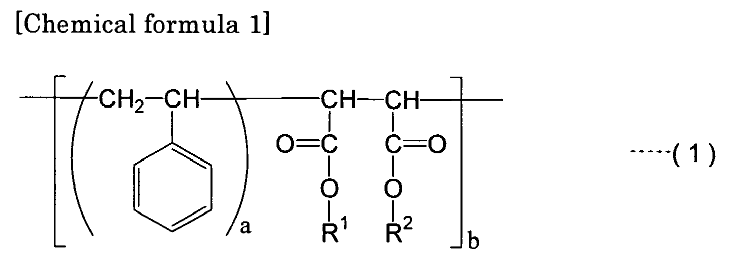 wherein each of "R¹" and "R²" independently represents a hydrogen atom or a substituted or unsubstituted alkyl group, "a" is an integer of 1 to 3, and "b" is an integer of 6 to 8.

7. The positive photosensitive composition according to claim 5 or 6,
wherein the compound having the hydroxyl group is alcohol.

8. The positive photosensitive composition according to any one of claims 1 to 7, the composition further comprising (D) a dissolution inhibitor.

9. The positive photosensitive composition according to claim 8,
wherein the dissolution inhibitor (D) is a compound represented by the following chemical formula (2):

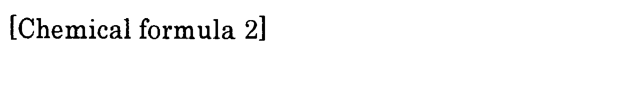

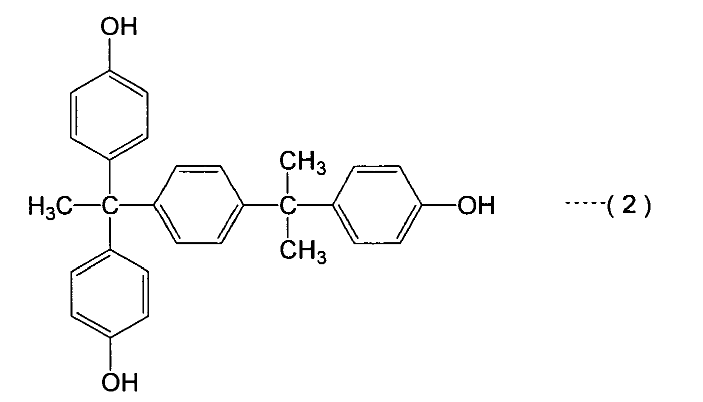

10. The positive photosensitive composition according to any one of claims 1 to 9, wherein the photo-thermal conversion material (C) is a compound represented by the following formula (3): 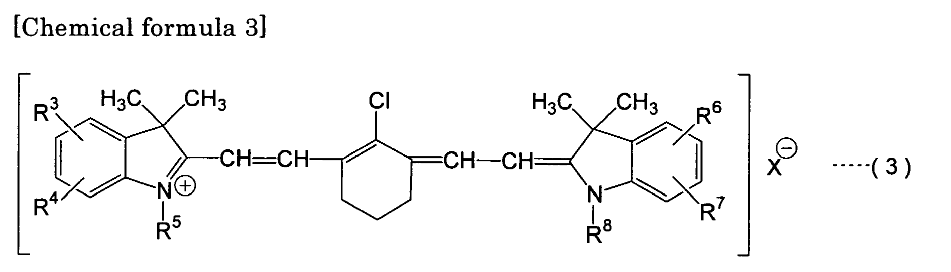 wherein each of R³ to R⁸ independently represents a hydrogen atom, an alkyl group having 1 to 3 carbon atoms or an alkoxyl group having 1 to 3 carbon atoms, and X represents a halogen atom, ClO₄ BF₄, p-CH₃C₆H₄SO₃ or PF₆.

11. The positive photosensitive composition according to any one of claims 1 to 9, wherein the photo-thermal conversion material (C) is a compound represented by the following formula (4): 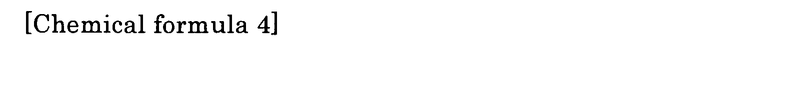 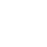 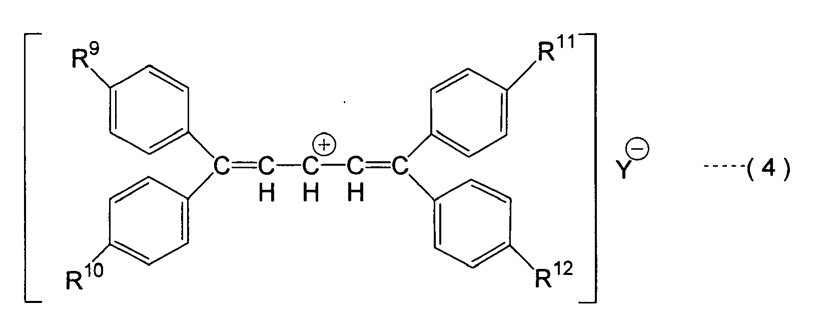 wherein each of R₉ to R₁₂ independently represents a hydrogen atom, a methoxyl group, -N(CH₃)₂ or -N(C₂H₅)₂, and Y represents C₄H₉-B(C₆H₅)₃, p-CH₃C₆H₄SO₃or CF₃SO₃.

12. The positive photosensitive composition according to any one of claims 1 to 11, the composition further comprising (E) a photo-acid generator.

13. The positive photosensitive composition according to claim 12,
wherein the photo-acid generator (E) is a compound represented by the following formula (5):

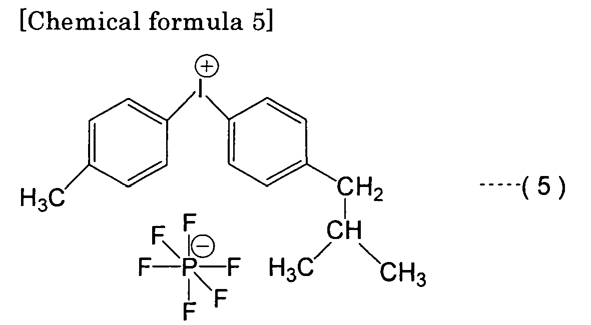

14. The positive photosensitive composition according to any one of claims 1 to 13, the composition further comprising (F) at least one resin selected from the group consisting of (1) a vinylpyrrolidone/vinyl acetate copolymer, (2) a vinylpyrrolidone/dimethylaminoethyl methacrylate copolymer, (3) a vinylpyrrolidone/vinylcaprolactam/dimethylaminoethyl methacrylate copolymer, (4) a polyvinyl acetate, (5) a polyvinyl butyral, (6) a polyvinyl formal, (7) a terpene phenolic resin, (8) an alkylphenolic resin, (9) a melamine/formaldehyde resin, and (10) a ketone resin.

15. The positive photosensitive composition according to any one of claims 1 to 14, the composition further comprising (G) a triarylmethane dye.

16. The positive photosensitive composition according to any one of claims 1 to 15, wherein the amine compound (B) is an aminoalcohol.

17. A photo-fabrication method using the positive photosensitive composition according to any one of claims 1 to 16.

18. The photo-fabrication method according to claim 17, which is applied to production of a printing plate, an electronic component, a precision equipment component and a component relating to a counterfeit deterrence.

19. A plate-making method, using the positive photosensitive composition according to any one of claims 1 to 16.
